(19) Europäisches Patentamt
European Patent Office
Office européen des brevets

(11) Veröffentlichungsnummer : **0 119 162**
**B1**

(12) # EUROPÄISCHE PATENTSCHRIFT

(45) Veröffentlichungstag der Patentschrift : **23.03.88**

(51) Int. Cl.⁴ : **G 03 C 1/68**, G 03 F 7/10

(21) Anmeldenummer : **84810070.7**

(22) Anmeldetag : **06.02.84**

(54) **Photopolymerisierbare Zusammensetzung, damit beschichtetes Material und Verfahren zur Herstellung von Reliefabbildungen.**

(30) Priorität : **11.02.83 CH 785/83**

(43) Veröffentlichungstag der Anmeldung : **19.09.84 Patentblatt 84/38**

(45) Bekanntmachung des Hinweises auf die Patenterteilung : **23.03.88 Patentblatt 88/12**

(84) Benannte Vertragsstaaten : **BE CH DE FR GB IT LI NL SE**

(56) Entgegenhaltungen :
**US-A- 4 329 419**
**JOURNAL OF POLYMER SCIENCE: POLYMER CHEMISTRY EDITION, Band 10, 1972, Seiten 2833-2840, John Wiley & Sons, Inc., New York, US; KYOJI KAERIYAMA u.a.: "Photopolymerization with the use of titanocene dichoride as sensitizer"**

(73) Patentinhaber : **CIBA-GEIGY AG**
**Klybeckstrasse 141**
**CH-4002 Basel (CH)**

(72) Erfinder : **Riediker, Martin, Dr.**
**Gstaltenrainweg 75**
**CH-4125 Riehen (CH)**
Erfinder : **Rohde, Ottmar, Dr.**
**Bärenfelserstrasse 34**
**CH-4057 Basel (CH)**
Erfinder : **Roth, Martin, Dr.**
**Oberdorf**
**CH-1711 Giffers (CH)**
Erfinder : **Bühler, Niklaus, Dr.**
**Route du Pâquier 8**
**CH-1723 Marly (CH)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

EP 0 119 162 B1

**Beschreibung**

Die vorliegende Erfindung betrifft eine photopolymerisierbare Zusammensetzung aus Polymer-Vorstufen mit photopolymerisierbaren Gruppen, einem Metallocen als Photoinitiator und gegebenenfalls Acrylaten, Methacrylaten, Allyläthern oder Allylestern von Polyolen, ein damit beschichtetes Substrat und ein Verfahren zur Herstellung photographischer Reliefabbildungen.

In der DE-A-2 308 830 ist ein Verfahren zur Herstellung von Reliefstrukturen beschrieben, bei dem man photopolymerisierbare Präpolymere, wie Polyamidsäureester, bildmässig belichtet, unbelichtete Anteile danach mit einem Entwickler entfernt und darauf die erhaltene Abbildung tempert, wobei das die Struktur bildende Präpolymer in ein bei hohen Temperaturen beständiges Polymer übergeführt wird.

Zur Erhöhung der Lichtempfindlichkeit solcher photopolymerisierbarer Präpolymere werden den Zusammensetzungen im allgemeinen Photoinitiatoren und Photosensibilisatoren zugesetzt, wie es z. B. in der DE-A-2 919 841 beschrieben ist. Mit diesen Zusammensetzungen wird jedoch noch keine befriedigende Empfindlichkeit erreicht, um mit kurzen Belichtungszeiten auch eine hohe Wirtschaftlichkeit zu erzielen.

So wird in der US-A-4 329 419 vorgeschlagen, einem Polyamidsäureester-Präpolymer eine polyfunktionelle Acrylatverbindung und ein aromatisches Bisimidazol als Photoinitiator zuzusetzen. Dieser Vorschlag vermag in verschiedener Hinsicht noch nicht zu befriedigen.

Die dort beschriebenen Mischungen enthalten relativ viel flüchtige organische Bestandteile, so dass die daraus hergestellten Reliefstrukturen beim Erhitzen auf 300-400 °C einem starken Schwund sowohl in horizontaler wie auch in vertikaler Richtung unterliegen, was zu grösseren Abweichungen der Reliefabbildung vom ursprünglichen Maskenbild führt. Der US-A-4 329 419 kann entnommen werden, dass eine Belichtungsenergie von 50 bis 120 mJ/cm$^2$ benötigt wird, um bei einer ursprünglichen Schichtstärke von 1,25 µm ein getreues Abbild der Maske zu erzeugen. Nach der thermischen Belastung beträgt die Schichtstärke nur noch 0,45 µm.

Weiterhin hat es sich als schwierig erwiesen, bei Schichtdicken $> 20$ µm befriedigende Ergebnisse zu erzielen. Die Eigenabsorption der Polymeren bei Wellenlängen $< 420$ nm bewirkt, dass die tieferliegenden Anteile der Schicht gegenüber den höherliegenden Anteilen unterbelichtet werden. Es ist daher sehr schwierig, relativ hohe Reliefprofile mit steilen Kantenflächen zu erzeugen und ein Unterlösen der Reliefstrukturen von der Substratoberfläche her zu vermeiden.

In der EP-A-65352 werden weiterhin photopolymerisierbare Zusammensetzungen beschrieben, die eine Polyamidsäure, ein Bisazid als Vernetzungsmittel, ein tertiäres Amin mit olefinisch ungesättigten Bindungen und gegebenenfalls einen Photosensibilisator enthalten. Die genannten Amine gehen mit den Carboxylgruppen der Polyamidsäure ionische Bindungen ein, die dann mit den aus den Bisadizen unter Belichtung entstehenden Nitrenen reagieren.

Diese Systeme enthalten teilweise sehr hohe Konzentationen an stark absorbierenden Sensibilisatoren und eignen sich nicht für die Herstellung von Reliefstrukturen mit relativ grosser Schichtstärke.

Hochauflösende Reliefstrukturen grosser Schichtdicke mit steilen Kantenflächen werden jedoch gerade bei Anwendungen wie z. B. in der europaïschen Patentveröffentlichung Nr. 68 414 beschrieben benötigt. Es hat sich auch als sehr wichtig herausgestellt, die Zusätze an flüchtigen organischen Additiven bei der Herstellung von Reliefstrukturen grosser Schichtdicke und damit die Kontraktion des Materials während der thermischen Belastung auf einem Minimum zu halten, weil sonst neben dem unwirtschaftlichen Schichtdickenverlust auch Risse und Ablösungen zu beobachten sind.

Es ist wünschenswert, photopolymerisierbare Polymer-Vorstufen (Präpolymere) von thermostabilen organischen Materialien derart zu sensibilisieren, dass

— eine hohe Lichtempfindlichkeit bei Wellenlängen über 400 nm erzielt wird,

— eine möglichst geringe Menge an photoaktiven Bestandteilen zugesetzt werden muss, um wirtschaftliche Belichtungszeiten zu erhalten,

— der Photoinitiator selbst oder dessen Bestandteile thermostabile Materialien darstellen, und

— als Lichtquellen z. B. auch Argon-Laser verwendet werden können.

In der EP-A-0 122 223 (Priorität : 11 Februar 1983 ; Anmeldetag : 6 Februar 1984 ; Veröffentlichungstag : 17 Oktober 1984) werden Polymer-Vorstufen vorgeschlagen unter die die Polymer-Vorstufen der vorliegenden Anmeldung generisch fallen. Letztere stellen eine Auswahl aus den vorgeschlagenen Polymer-Vorstufen dar.

Gegenstand vorliegender Erfindung ist eine photopolymerisierbare Zusammensetzung, die neben üblichen Zusätzen, z. B. Lösungsmitteln,

a) eine Polymer-Vorstufe mit gleichen oder verschiedenen wiederkehrenden Strukturelementen der Formel I

(Siehe Formel I Seite 3 f.)

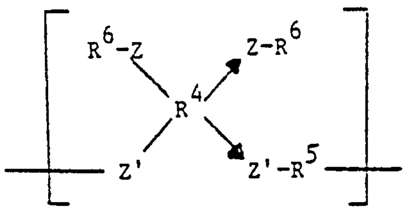

(I)

die beim Erwärmen zu einer thermostabilen Ringstruktur reagiert,

b) einen Photoinitiator und gegebenenfalls,

c) einen Acrylsäureester, Methacrylsäureester, Allyläther oder Allylester oder Teilester dieser Säuren mit einem Polyol enthält, dadurch gekennzeichnet, dass der Photoinitiator (b) ein Metallocen der Formel II

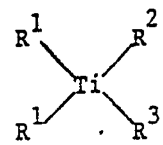

(II)

ist, worin

beide $R^1$ unabhängig voneinander unsubstituiertes oder substituiertes Cyclopentadienyl$^{\ominus}$, Indenyl$^{\ominus}$ oder beide $R^1$ zusammen einen unsubstituierten oder substituierten Rest der Formel III

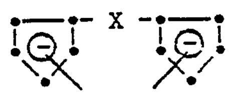

(III)

darstellen,

$R^2$ einen carbocyclischen oder einen 5- oder 6-gliedrigen heterocyclischen aromatischen Ring bedeutet, der in mindestens einer der beiden Orthostellungen zur Metallkohlenstoffbindung durch ein Fluoratom substituiert ist und weitere Substituenten enthalten kann,

$R^3$ $C_{3-5}$-Alkinyl, substituiertes oder unsubstituiertes Phenylalkinyl mit 3-5 Kohlenstoffatomen in der Alkinylgruppe, $N_3$, CN, $Si(R^7)_3$ oder $Sn(R^7)_3$ darstellt oder die Bedeutung von $R^2$ hat oder $R^2$ und $R^3$ zusammen einen Rest der Formel IV

$$—Q—Y—Q— \qquad (IV)$$

bedeuten,

$R^4$ ein vierwertiger aromatischer Rest nach Entfernen von vier funktionellen Gruppen ist, wobei je zwei funktionelle Gruppen benachbart sind und ⟶ für Strukturisomere steht,

$R^5$ einen zweiwertigen aliphatischen, cycloaliphatischen oder ein- oder mehrkernigen aromatischen Rest bedeutet, wobei aromatische Reste $R^5$ in ortho-Stellung zur Bindung an Z' eine Gruppe $—CONH_2$ oder —COOH aufweisen können,

$R^6$ für einen Rest mit einer photopolymerisierbaren olefinischen Doppelbindung steht,

$R^7$ $C_1$-$C_{12}$-Alkyl, $C_5$-$C_{12}$-Cycloalkyl, $C_6$-$C_{16}$-Aryl oder $C_7$-$C_{16}$-Aralkyl bedeutet,

die Z ein kovalentes oder ionisches Bindungsglied und die Z' ein kovalentes Bindungsglied bedeuten, mit der Massgabe, dass Z und Z' beim Erwärmen der photopolymerisierbaren Zusammensetzung unter Abspaltung von $R^6$, gegebenenfalls zusammen mit in $R^5$ enthaltenen Gruppen $—CONH_2$ oder —COOH, eine thermostabile Ringstruktur ergeben,

$X(CH_2)_n$ mit n = 1, 2 oder 3, Alkyliden mit 2-12 C-Atomen, Cycloalkyliden mit 5-7 Ringkohlenstoffatomen, $Si(R^7)_2$ oder $Sn(R^7)_2$ ist,

Q für einen carbocyclischen oder heterocyclischen 5- oder 6-gliedrigen aromatischen Ring steht, wobei die beiden Bindungen jeweils in ortho-Stellung zur Gruppe Y stehen und die meta-Stellung zur Gruppe Y jeweils durch ein Fluoratom substituiert ist und Q weitere Substituenten enthalten kann, und Y $CH_2$, Alkyliden mit 2-12 C-Atomen, Cycloalkyliden mit 5-7 Ringkohlenstoffatomen, eine direkte Bindung, $NR^7$, O, S, SO, $SO_2$, CO, $Si(R^7)_2$ oder $Sn(R^7)_2$ bedeutet.

Die erfindungsgemässen photopolymerisierbaren Zusammensetzungen auf der Basis von photopolymerisierbaren Polymer-Vorstufen weisen eine hohe Lichtempfindlichkeit über einen Wellenlängenbereich vom UV-Licht bis zum sichtbaren Licht auf, können in sehr dünnen Schichten (z. B. 0,05 bis 4 µm) und dickeren Schichten (z. B. 20-500 µm) photopolymerisiert werden und liefern photographische Reliefstrukturen mit hohen Auflösungen und naturgetreue Abbildungen, die eine relativ geringe Kontraktion bei der thermischen Belastung aufweisen und die eine wirtschaftliche Herstellung von Reliefstrukturen auch grosser Schichtdicke erlauben.

Die Mitverwendung der Komponente (c) ist erfindungsgemäss nicht unbedingt erforderlich, jedoch bevorzugt, da damit eine wesentliche Erhöhung der Lichtempfindlichkeit der photopolymerisierbaren Zusammensetzung (Verkürzung der Belichtungszeiten) erzielt werden kann. Der Photoinitiator (b) ist

vorzugsweise in einer Menge von 0,1 bis 20, besonders 0,5 bis 10 Gew.% zugegen, bezogen auf die Komponente (a) bzw. die Komponenten (a) und (c). Die Zusammensetzung enthält die Komponente (a) vorzugsweise in einer Menge von 50 bis 97,5, besonders 70 bis 95 Gew.%, und die Komponente (c) vorzugsweise in einer Menge von 2,5 bis 50, besonders 5 bis 30 Gew.%. Besonders bevorzugt sind Zusammensetzungen, die 85 bis 90 Gew.% der Komponente (a) und 10 bis 15 Gew.% der Komponente (c) enthalten.

In den Polymer-Vorstufen (a) können die $R^4$, $R^5$, $R^6$, Z und Z′ in den einzelnen Strukturelementen gleiche oder verschiedene Bedeutungen haben. Bei Copolymeren können die einzelnen Strukturelemente statistisch angeordnet sein, oder es kann sich um Blockcopolymere handeln, die nach an sich bekannten Methoden durch Verknüpfung verschiedener Blöcke hergestellt werden können. Wenn Z ein ionisches Bindungsglied darstellt, können auch aus Strukturelementen der Formel I erhaltene cyclisierte Derivate mit Polymer-Vorstufen mit wiederkehrenden Strukturelementen verknüpft werden.

Das mittlere Molekulargewicht ($\overline{M}_w$) der Polymer-Vorstufen beträgt vorzugsweise 5 000 bis 100 000, besonders 5 000 bis 50 000 und ganz besonders 10 000 bis 30 000. Die mittleren Molekulargewichte können z. B. durch Aufnahme von Gelpermeations-Chromatogrammen mit Polystyrol-Eichung bestimmt und verglichen werden.

Aromatische Reste $R^4$ können ein- oder mehrkernig und gegebenenfalls auch substituiert sein, z. B. durch Halogenatome, Alkyl- oder Alkoxygruppen mit je 1-4 C-Atomen. $R^4$ stellt z. B. einen Naphthalin-, Phenanthren- oder Perylenrest und insbesondere einen Rest der Formel V oder VI

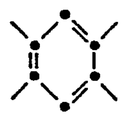 (V) oder 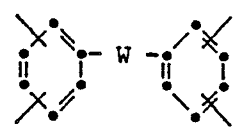 (VI)

dar, worin W eine direkte Bindung, O, CO, $CH_2$, $C(CF_3)_2$, S, SO, $SO_2$, NH oder Alkyliden mit 2-12 C-Atomen bedeutet. Besonders bevorzugt stellt $R^4$ den Rest des Pyromellitsäuredianhydrids, eines Benzophenontetracarbonsäuredianhydrids oder eines Gemisches davon dar.

$R^5$ in der Bedeutung eines aliphatischen Restes enthält bevorzugt 2-20 C-Atome und kann z. B. lineares oder verzweigtes Alkylen sein, das durch Silan- oder Siloxangruppen unterbrochen sein kann. In der Bedeutung als cycloaliphatischer Rest enthält $R^5$ bevorzugt 5-7 Ringkohlenstoffatome und ist insbesondere Cyclohexylen, Cyclopentylen oder der Rest des Isophorondiamins. $R^5$ ist vorzugsweise ein aromatischer Rest mit insbesondere 6-16 C-Atomen, der auch substituiert sein kann, z. B. durch Halogenatome, OH, —COOH, —$CONH_2$, Alkyl- oder Alkoxygruppen mit 1-4 C-Atomen. Besonders bevorzugt stellt $R^5$ einen Rest der Formeln VII, VIII oder IX

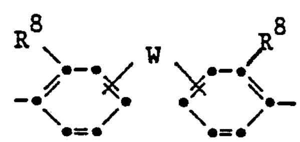 (VII), 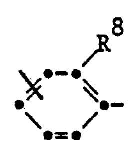 (VIII)

oder

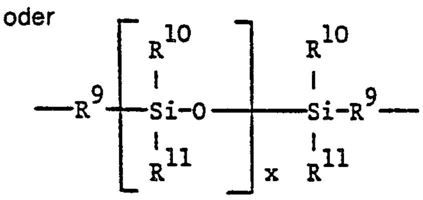 (IX) dar, wobei

W die oben angegebene Bedeutung hat und insbesondere O, $CH_2$ oder $C(CF_3)_2$ darstellt,

x eine ganze Zahl von 1-10, besonders 1-5 und vor allem 1, die $R^8$ unabhängig voneinander ein Wasserstoffatom, —$CONH_2$ oder —COOH,

$R^9$ —$C_pH_{2p}$— mit p = 1-5 und

$R^{10}$ und $R^{11}$ unabhängig voneinander geradkettiges oder verzweigtes Alkyl mit 1-6 C-Atomen, besonders Methyl, darstellen. Als Reste der Formeln VII und VIII werden in para-Stellung bzw. 4,4′-Stellung gebundene Reste bevorzugt.

Die Gruppe $R^6$ weist bevorzugt die Formel X

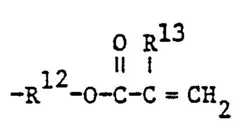 (X)

auf, worin $R^{12}$ —$C_mH_{2m}$— mit m = 2-12, wie Aethylen, 1,2- oder 1,3-Propylen, 1,2-, 1,3- oder 1,4-Butylen-, n-Pentylen, n-Hexylen, n-Octylen oder n-Dodecylen, —$CH_2CH(OH)CH_2$— oder Polyoxaalkylen mit 4-30 C-Atomen, wie die Reste von Diäthylenglykol, Triäthylenglykol, Tetraäthylenglykol, Polyäthylenglykol,

Dipropylenglykol oder Polypropylenglykol bedeutet, und $R^{13}$ ein Wasserstoffatom oder Methyl ist. Bei $Z = -COO-$ kann $R^6$ auch $-CH{=}CH_2$, $-CH_2CH{=}CH_2$ oder $-CH_2C(CH_3{=}CH_2)$ sein. $R^{12}$ ist bevorzugt Aethylen, 1,2- oder 1,3-Propylen oder $-CH_2CH(OH)CH_2-$ und $R^{13}$ ist insbesondere Methyl.

Bevorzugt sind Polymer-Vorstufen (a), worin $R^5$ in 0-100 % der wiederkehrenden Strukturelemente einen Rest der Formel VII und in 100-0 % der wiederkehrenden Strukturelemente einen Rest der Formel VIII darstellt, sowie Polymer-Vorstufen, worin $R^5$ in 70-100 % der wiederkehrenden Strukturelemente einen Rest der Formel VII und/oder VIII und in 30-0 % der wiederkehrenden Strukturelemente einen Rest der Formel IX bedeutet.

Z kann definitionsgemäss eine kovalente oder ionische Bindung darstellen. Als ionische Bindungen kommen vor allem solche zwischen Carboxylgruppen und tertiären Aminen in Betracht. Z ist vorzugsweise $-COO-$, $-CONH-$, $-O-$, $-NH-$, $-COOH/NR^{14}R^{15}-$ oder

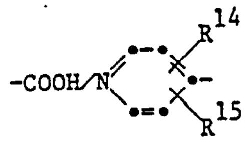 ,

worin $R^{14}$ und $R^{15}$ unabhängig voneinander Alkyl oder Alkenyl mit bis zu 6 C-Atomen, besonders je Methyl, darstellen. Z' bedeutet bevorzugt $-CONH-$, $-NHCO-$, $-NH-CO-NH-$ oder $-O-CO-NH-$. Besonders bevorzugt ist Z $-CONH-$, $-COO-$ oder $-COOH/N(CH_3)_2-$ und Z' stellt $-CONH-$ dar, oder Z ist $-O-$, und Z' bedeutet $-NHCO-$.

Die Gruppen Z und Z' müssen definitionsgemäss beim Erwärmen unter Abspaltung der Gruppen $R^6$, gegebenenfalls zusammen mit in $R^5$ enthaltenen Gruppen $-CONH_2$ oder $-COOH$, thermostabile Ringstrukturen ergeben. Dabei kann es sich je nach Art der Gruppen Z und Z' bzw. um folgende Ringstrukturen handeln

($R^4$ = 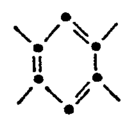

und $R^5$ = aromatischer Rest, Ar, der auch Bestandteil der Ringstruktur sein kann):

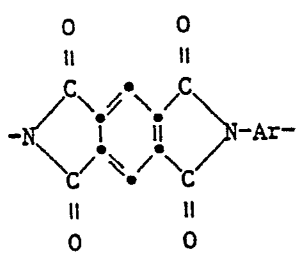 (A, Polyimide),

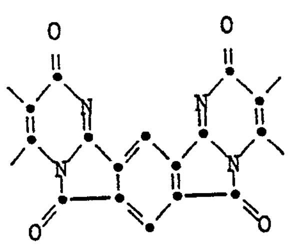 [B, Poly(isoindolochinazolidindione)],

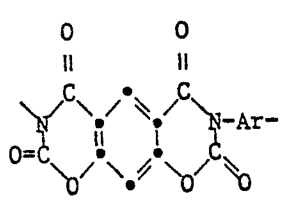 [C, Poly(oxazindione)],

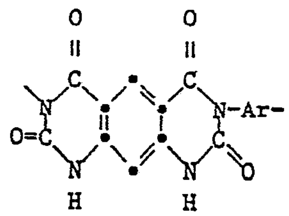

[D, Poly(chinazolindione)],

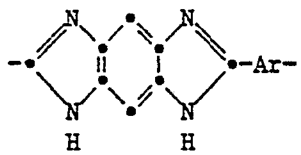

[E, Poly(imidazole)],

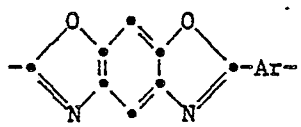

[F, Poly(oxazole)] und

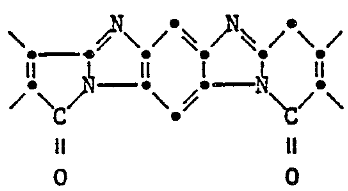

[G, Poly(imidazopyrrolone)].

Die Herstellung dieser Ringstrukturen und der entsprechenden Präpolymere kann z. B. wie folgt schematisch dargestellt werden :

Weg I

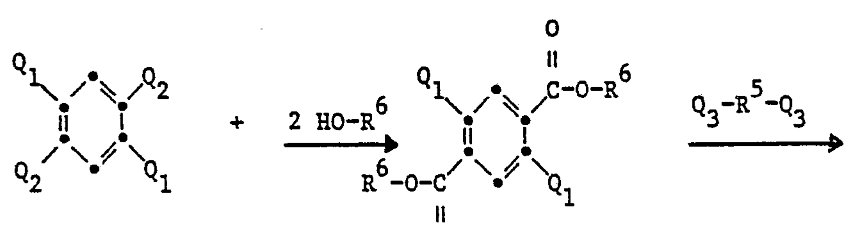


(H) (J) (K)

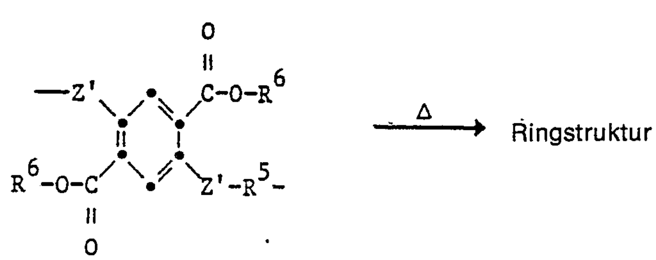

Weg IIa

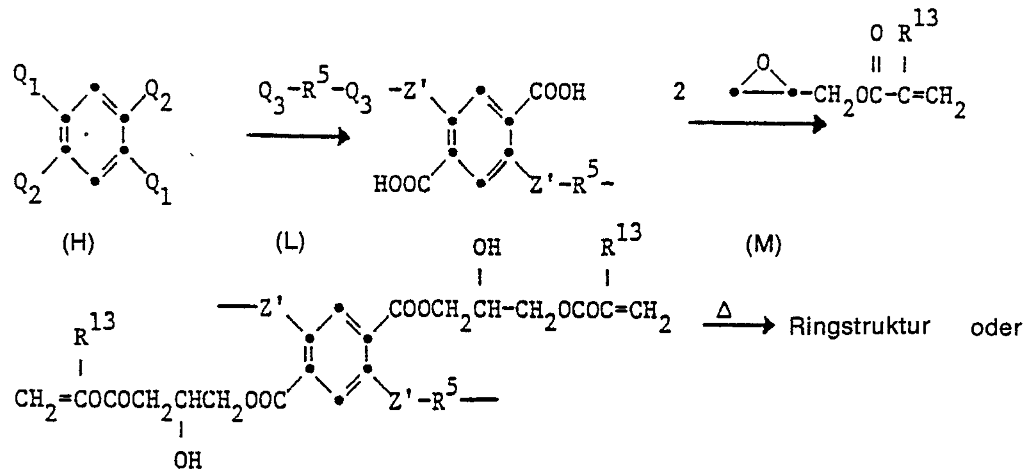


(H) (L) (M)

Weg IIb

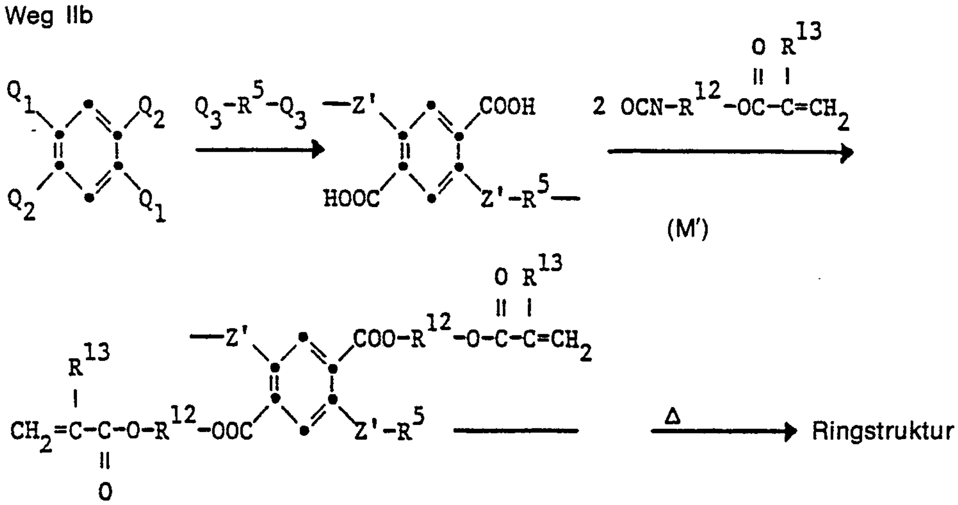


(M')

Dabei ist $Q_1$ z. B. COOH, COCl, $NH_2$ oder OH oder $Q_1$ und $Q_2$ bilden zusammen —CO—O—CO— und $Q_3$ ist z. B. $NH_2$ oder NCO. Nach diesen Verfahren lassen sich identische Polymere herstellen, z. B. über Präpolymere mit den Strukturelementen :

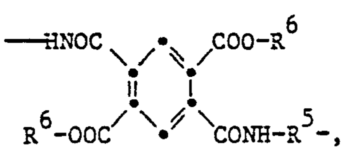

(ergibt Ringstrukturen A)

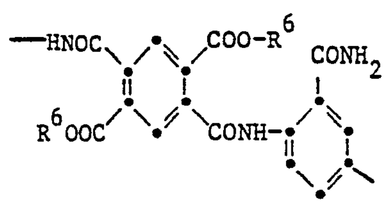

(ergibt Ringstrukturen B)

,

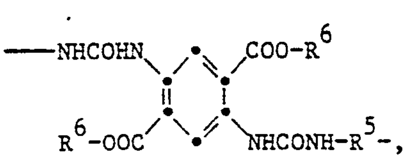

(ergibt Ringstrukturen D)

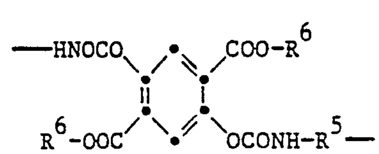

(ergibt Ringstrukturen C)

Weg III

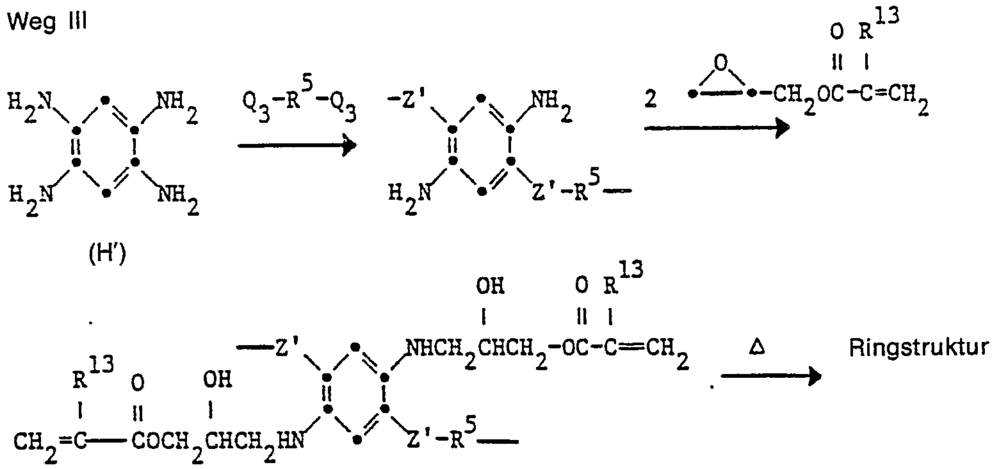


(H')

Dabei ist $Q_3$ z. B. COCl oder bildet zusammen mit einer o-ständigen Carboxylgruppe an einem aromatischen $R^5$ eine Anhydridgruppierung.

Nach diesem Verfahren lassen sich z. B. Präpolymere mit folgenden Strukturelementen herstellen :

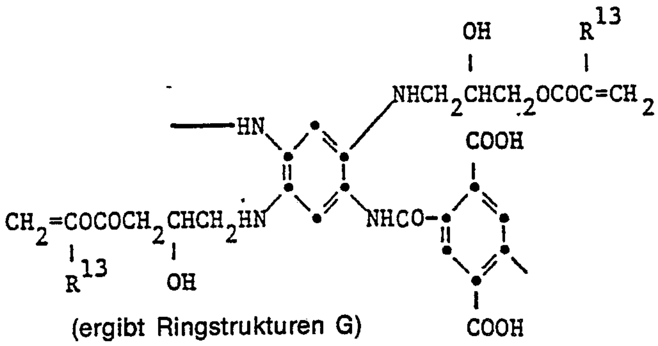

(ergibt Ringstrukturen G)

und

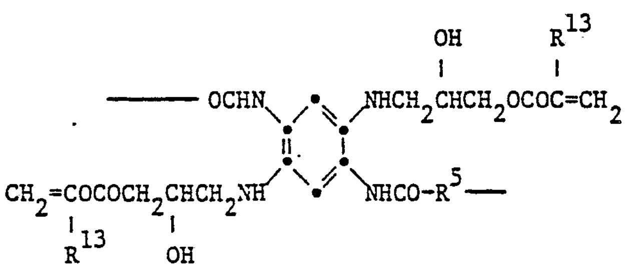

(ergibt Ringstrukturen E)

Weg IV

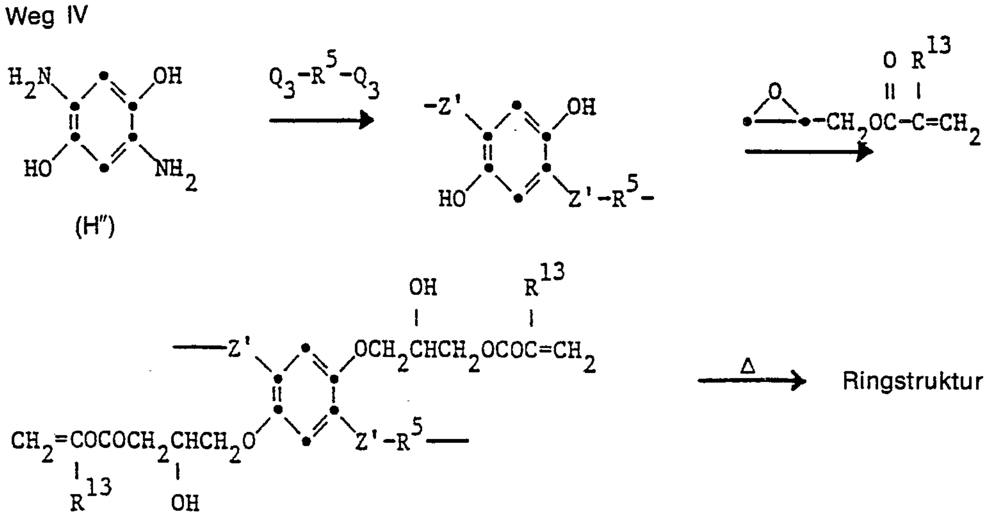


(H")

Dabei ist $Q_3$ z. B. COCl. Nach diesem Verfahren lassen sich z. B. Präpolymere mit Strukturelementen der Formel

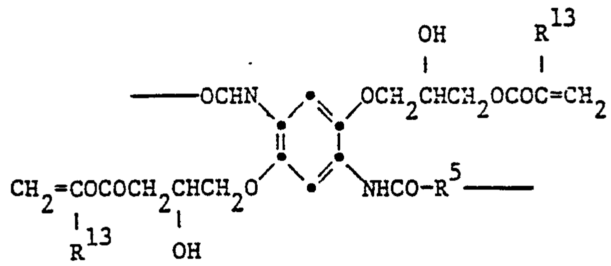

herstellen

(ergibt Ringstrukturen F).

Polymer-Vorstufen, worin die Z —COOH/$NR^{14}R^{15}$— oder

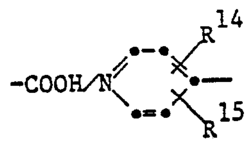

darstellen, können z. B. analog dem in der europaïschen Patentveröffentlichung Nr. 65352 beschriebenen Verfahren hergestellt werden.

Besonders bevorzugt sind Polymer-Vorstufen mit wiederkehrenden Strukturelementen der Formel Ia

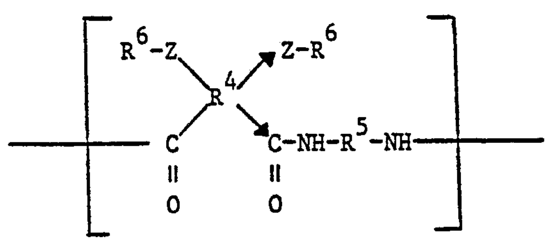

(Ic)

worin $R^4$ der vierwertige Rest einer aromatischen Tetracarbonsäure nach Entfernen von vier Carboxylgruppen ist und $R^5$, $R^6$ und Z die unter Formel I angegebene Bedeutung haben. Z stellt dabei vorzugsweise —CO—O— dar.

Des weiteren sind Polymer-Vorstufen mit wiederkehrenden Strukturelementen der Formel Ib

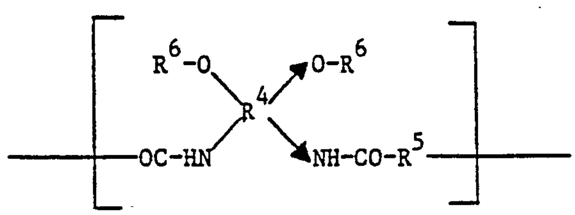

(Ib)

bevorzugt, worin $R^4$ der Rest des 3,3'-Dihydroxybenzidins ist, die $R^5$ in den einzelnen wiederkehrenden Strukturelementen unabhängig voneinander den Rest der Isophthalsäure oder der 4,4'-Benzophenondicarbonsäure darstellen und $R^6$ die unter Formel I angegebene Bedeutung hat.

Die durch ⟶ angedeutete Strukturisomerie kann z. B. mit Pyromellitsäure folgendermassen dargestellt werden (Z = —CO—O—) :

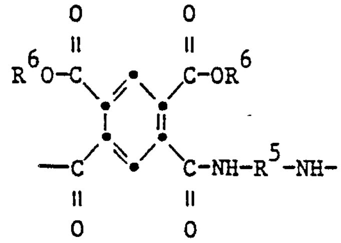

oder

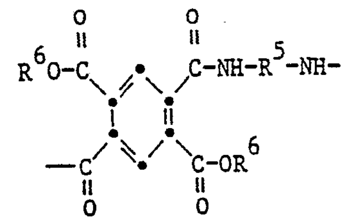

Die Polymer-Vorstufen (a) sind bekannt oder können nach an sich bekannten Methoden hergestellt werden (vgl. z. B. das obige Reaktionsschema und die US Patentschriften 4.329.419 und 4.030.948).

Geeignete Verbindungen H, H′ und H″ zur Herstellung der Polymer-Vorstufen (a) sind z. B. 2,3,9,10-Perylentetracarbonsäuredianhydrid, 1,4,5,8-, 2,3,6,7-, 1,2,4,5- und 1,2,5,6-Naphthalintetracarbonsäuredianhydrid, 2,6-Dichlornaphthalin-1,4,5,8-tetracarbonsäuredianhydrid, 2,7-Dichlornaphthalin-1,4,5,8-tetracarbonsäuredianhydrid, 2,3,6,7-Tetrachlornaphthalin-1,4,5,8-tetracarbonsäuredianhydrid, Phenanthren-1,8,9,10-tetracarbonsäuredianhydrid, Pyromellitsäuredianhydrid, 2,3,3′,4′-, 3,3′,4,4′- und 2,2′,3,3′-Benzophenontetracarbonsäuredianhydrid, 2,2′,3,3′- und 3,3′,4,4′-Biphenyltetracarbonsäuredianhydrid, 4,4′-Isopropylidendiphthalsäureanhydrid, 3,3′-Isopropylidendiphthalsäureanhydrid, 3,3′- und 4,4′-Oxydiphthalsäureanhydrid, 4,4′-Sulfonyldiphthalsäureanhydrid, 4,4′-Methylendiphthalsäureanhydrid, 4,4′-Thiodiphthalsäureanhydrid, 4,4′-Aethylidendiphthalsäureanhydrid, Benzol-1,2,3,4-tetracarbonsäuredianhydrid, 1,2,4,5-Tetraaminobenzol, 1,4-Diamino-2,5-dihydroxybenzol, 1,4-Dicarboxy-2,5-dihydroxybenzol.

Beispiele für Verbindungen K zur Herstellung der Polymer-Vorstufen (a) sind :

m- und p-Phenylendiamin, 4,4′- und 3,3′-Diaminobiphenyl, 4,4′- und 3,3′-Diaminodiphenyläther, 4,4′- und 3,3′-Diaminodiphenylmethan, 4,4′- und 3,3′-Diaminodiphenylsulfon, 4,4′- und 3,3′-Thiodianilin, Bis-(4-aminophenyl) bis(trifluormethyl) methan, 4,4′-Diaminobenzophenon, 1,5-Diaminonaphthalin, Bis-(4-aminophenyl)-dimethylsilan, Bis-(4-aminophenyl)-diäthylsilan, Bis-(4-aminophenyl)-diphenylsilan, Bis-(4-aminophenyloxy)-dimethylsilan, 4,4′-Methylenbis-(o-chloranilin), 4,4′-Methylenbis-(3-methylanilin), 4,4′-Methylenbis-(2-äthylanilin), 4,4′-Methylenbis-(2-methoxyanilin), 5,5′-Methylenbis-(2-aminophenol), 4,4′-Methylenbis-(2-methylanilin), 4,4′-Oxybis-(2-methoxyanilin), 4,4′-Oxybis-(2-chloranilin), 5,5′-Oxybis-(2-aminophenol), 4,4′-Thiobis-(2-methylanilin), 4,4′-Thiobis-(2-methoxyanilin), 4,4′-Thiobis-(2-chloranilin), 4,4′-Sulfonylbis-(2-methylanilin), 4,4′-Sulfonylbis-(2-äthoxyanilin), 4,4′-Sulfonylbis-(2-chloranilin), 5,5′-Sulfonylbis-(2-aminophenol), 3,3′-Dimethyl-4,4′-diaminobenzophenon, 3,3′-Dimethoxy-4,4′-diaminobenzophenon, 3,3′-Dichlor-4,4′-diaminobenzophenon, 4,4′-Oxydianilin, 4,4′-Isopropylidendianilin, 3,3′-Dichlorbenzidin, 3,3′-Dimethylbenzidin, 3,3′-Dimethoxybenzidin, 3,3′-Dicarboxybenzidin, Diaminotoluol, 4,4′-Methylen-bis-(3-carboxyanilin) und dessen Ester, 4,4′-Diamino-3-carbonamidobiphenyl, 4,4′-Diamino-3,3′-bis-carbonamidobiphenyl, 4,4′-Diamino-3-carbonamidodiphenyläther, 4,4′-Diamino-3,3′-bis-carbonamidodiphenyläther, 4,4′-Diamino-3-carboxydiphenyläther, 4,4′-Diamino-3,3′-dicarboxydiphenyläther, 4,4′-Diisocyanatodiphenyläther, Diphenyläther-4,4′-dicarbonsäurechlorid, Isophthalsäuredichlorid, 1,3- und 1,4-Phenylendiisocyanat und Pyromellitsäuredianhydrid.

Besonders bevorzugt sind Zusammensetzungen, worin die Polymer-Vorstufe (a) aus wiederkehrenden Strukturelementen der Formel Ic

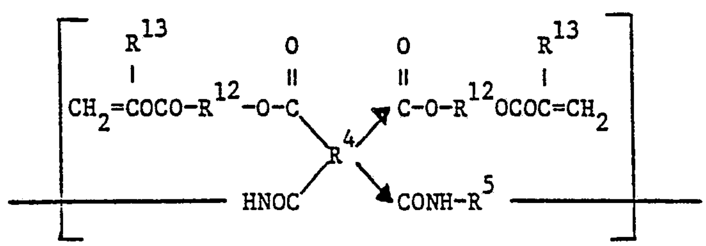

(Ic)

besteht, worin $R^4$ den Rest des Pyromellitsäuredianhydrids, eines Benzophenontetracarbonsäuredianhydrids oder ein Gemisch solcher Reste darstellt, die $R^5$ in den einzelnen wiederkehrenden Strukturelementen unabhängig voneinander 1,3- oder 1,4-Phenylen, den Rest des 4,4′-Diaminodiphenyläthers, 4,4′-Diaminodiphenylmethans, 2,2-Bis-(4,4′-Diaminodiphenyl) hexafluoropropans, 4,4′-Diamino-3-carbonamidodiphenyläthers oder 4,4′-Diamino-3,3′-bis-carbonamidobiphenyls darstellen, $R^{12}$ $—CH_2CH_2—$ oder $—CH_2CH(OH)CH_2—$ und $R^{13}$ ein Wasserstoffatom oder Methyl bedeuten, sowie Zusammensetzungen, worin die Polymer-Vorstufe (a) aus wiederkehrenden Strukturelementen der Formel Id

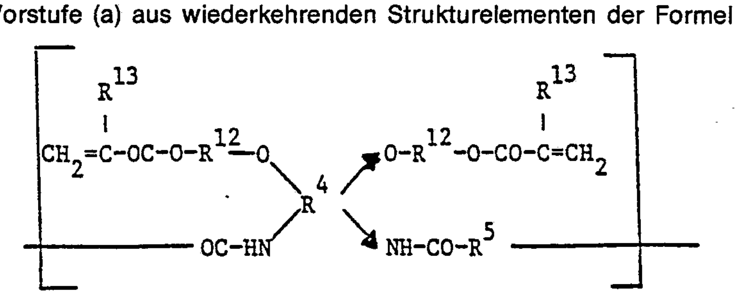

(Id)

besteht, worin $R^4$ den Rest des 3,3'-Dihydroxybenzidins, die $R^5$ in den einzelnen wiederkehrenden Strukturelementen unabhängig voneinander 1,3-Phenylen oder den Rest der 4,4'-Benzophenondicarbonsäure, $R^{12}$ $-CH_2CH_2-$, $-CH_2CH_2CH_2-$ oder $-CH_2-CH(OH)-CH_2-$ und $R^{13}$ ein Wasserstoffatom oder Methyl darstellen.

Im speziellen seien Polymer-Vorstufen mit wiederkehrenden Strukturelementen der Formeln Ie bis Ik erwähnt :

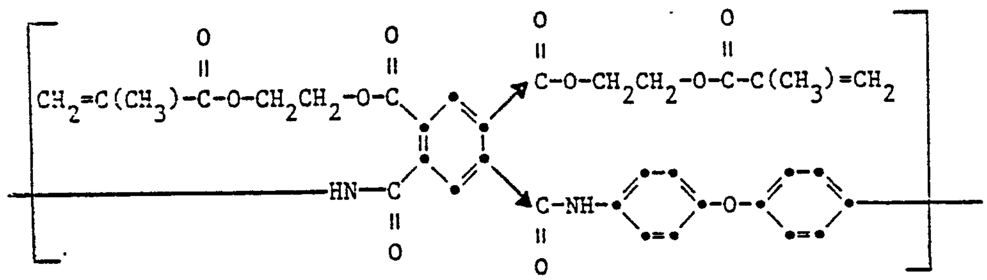

(Ie)

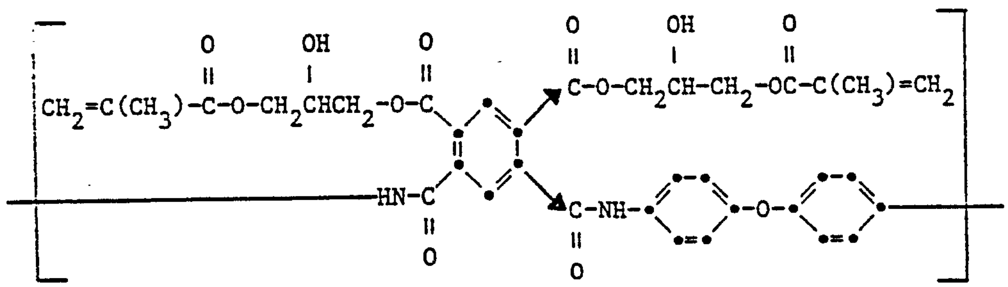

(If),

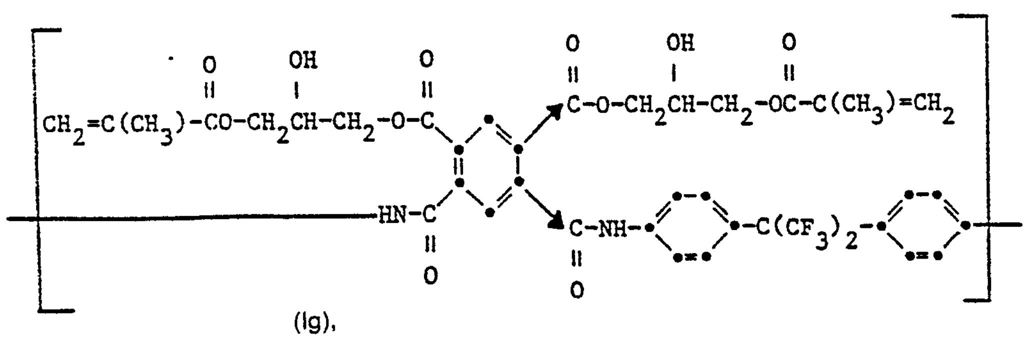

(Ig),

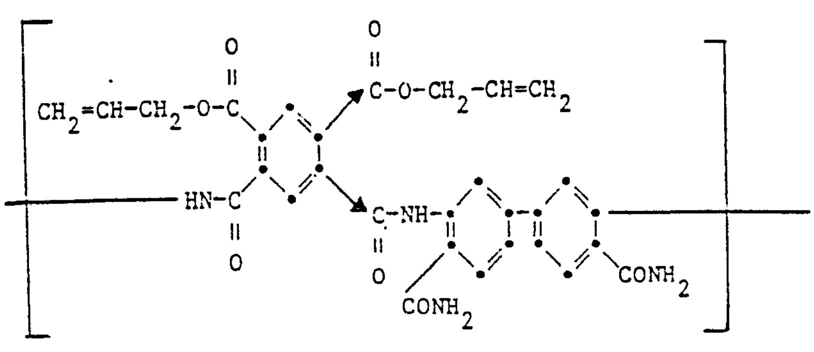

(Ih),

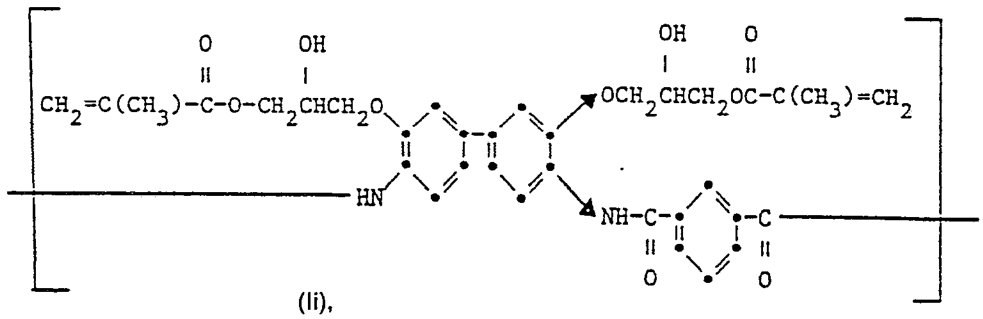

(Ii),

und

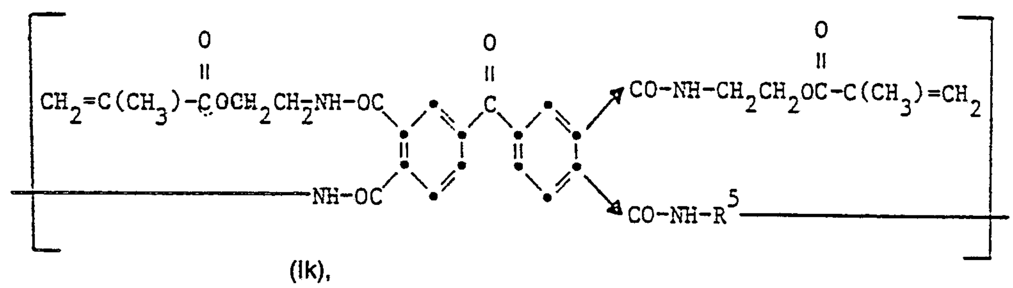

(Ik),

worin $R^5$ in 70 % der Strukturelemente

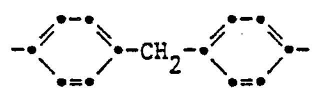

und in 30 % der Strukturelemente

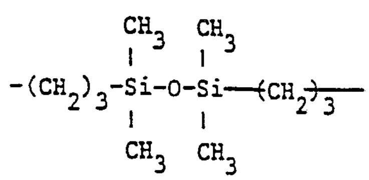

ist.

Die Metallocene der Formel II sind bekannt [vgl. z. B. J. Organomet. Chem., 2 (1964), Seiten 206-212 und J. Organomet. Chem. 4 (1965), Seiten 446-445] oder können nach analogen Verfahren hergestellt werden.

Bei den Gruppen $R^1$ handelt es sich bevorzugt um gleiche Reste. Als Substituenten für durch $R^1$ dargestellte Gruppen kommen in Frage : Lineares und verzweigtes Alkyl, Alkoxy und Alkenyl mit bevorzugt bis zu 18, besonders bis zu 12 und insbesondere bis zu 6 C-Atomen, wie Methyl, Aethyl, Propyl, Isopropyl, n-Butyl, tert.-Butyl, Pentyl, Hexyl, Octyl, Decyl, Dodecyl, Tetradecyl, Hexadecyl, Octadecyl und entsprechende Alkenyl- und Alkoxygruppen ; Cycloalkyl und Cycloalkenyl mit bevorzugt 5 bis 8 Ringkohlenstoffatomen, wie z. B. Cyclopentyl, Cyclohexyl, Cycloheptyl, Methylcyclopentyl und Methylcyclohexyl ; Aryl mit bevorzugt 6 bis 16 C-Atomen und Aralkyl mit bevorzugt 7 bis 16 C-Atomen ; wie z. B. Phenyl, Naphtyl, Biphenyl, Benzyl und Phenyläthyl ; Nitril, Halogen, besonders F, Cl und Br, sowie Aminogruppen, besonders tertiäre Aminogruppen, die lineare oder verzweigte Alkylgruppen mit 1 bis 12, besonders 1 bis 6 C-Atomen und insbesondere Methyl und Aethyl, Phenyl und Benzyl enthalten können. Die Aminogruppen können auch quaternisiert sein, besonders mit linearen oder verzweigten Alkylhalogeniden mit vorzugsweise 1 bis 12 C-Atomen, besonders Methyl- oder Aethylhalogeniden ; lineares oder verzweigtes Aminoalkyl, besonders tertiäres Aminoalkyl, das auch quaternisiert sein kann, besonders mit Alkylhalogeniden. Die Alkylengruppe im Aminoalkyl kann linear oder verzweigt sein und enthält bevorzugt 1 bis 12, insbesondere 1 bis 6 C-Atome und ist ganz besonders α-verzweigtes Alkyl mit 1-12 C-Atomen.

Die Reste $R^1$ können bis zu 3, besonders aber 1, Substituenten enthalten. Insbesondere sind beide $R^1$ Cyclopentadienyl$^{\ominus}$ oder Methylcyclopentadienyl$^{\ominus}$.

Alkylidengruppen X, Y und W enthalten bevorzugt 2 bis 6 C-Atome. Beispiele für Alkylidengruppen X, Y und W und Cycloalkylidengruppen X und Y sind Aethyliden, 2,2-Propyliden, Butyliden, Hexyliden, Phenylmethylen, Diphenylmethylen, Cyclopentyliden und Cyclohexyliden. Besonders bevorzugt ist X

Methylen. $R^4$ in seiner Bedeutung als Alkyl enthält bevorzugt 1 bis 6 C-Atome und ist z. B. Methyl, Aethyl, Propyl, Butyl oder Hexyl. In seiner Bedeutung als Cycloalkyl ist $R^4$ bevorzugt Cyclopentyl oder Cyclohexyl, in seiner Bedeutung als Aryl bevorzugt Phenyl und in seiner Bedeutung als Aralkyl bevorzugt Benzyl.

Der Rest $R^2$ ist bevorzugt in beiden Orthostellungen durch Fluor substituiert.

Bei $R^2$ in seiner Bedeutung als carbocyclischer aromatischer und fluor-substituierter Ring kann es sich um Inden, Indan, Fluoren, naphthalin und besonders Phenyl handeln. Beispiele sind : 4,6-Difluorinden-5-yl, 5,7-Difluorinden-6-yl, 2,4-Difluorfluoren-3-yl, 1,3-Difluornaphth-2-yl und besonders 2,6-Difluorphen-1-yl.

$R^2$ als heterocyclischer aromatischer und 5-gliedriger Ring enthält bevorzugt ein Heteroatom und als 6-gliedriger Ring bevorzugt 1 oder 2 Heteroatome. Beispiele für solche mit 2 Fluoratomen substituierte Ringe sind : 2,4-Difluorpyrrol-3-yl, 2,4-Difluorfur-3-yl, 2,4-Difluorthiophen-3-yl, 2,4-Difluorpyrid-3-yl, 3,5-Difluorpyrid-4-yl, 4,6-Difluorpyrimid-5-yl.

$R^2$ und $R^3$ zusammen als Rest der Formel IV können z. B. sein :

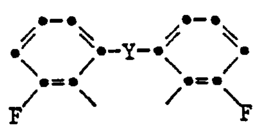 , 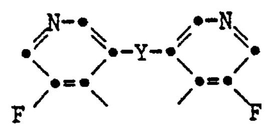 ,

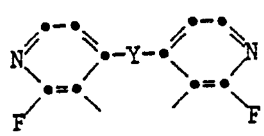 , 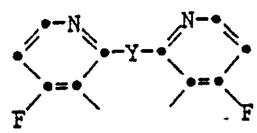 ,

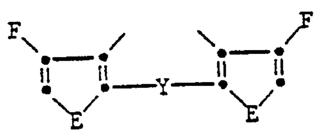 und 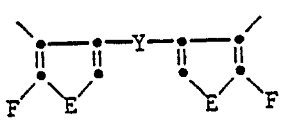 ,

worin E, O, S oder NH darstellt. Y ist bevorzugt Methylen, Aethyliden, 2,2-Propyliden, eine direkte Bindung oder O.

Die Reste $R^2$ sowie die Gruppen Q in Resten der Formel IV können teilweise oder vollständig durch weitere Gruppen substituiert sein. Geeignete Gruppen sind : Lineares oder verzweigtes Alkyl oder Alkoxy mit bevorzugt 1 bis 18, insbesondere 1 bis 6 C-Atomen, z. B. Methyl, Aethyl, Propyl, Butyl, Pentyl, Hexyl und die entsprechenden Alkoxygruppen, besonders Methyl und Methoxy ; Cycloalkyl mit bevorzugt 5 oder 6 Ringkohlenstoffatomen, Aryl mit bevorzugt 6 bis 16 C-Atomen und Aralkyl mit bevorzugt 7 bis 16 C-Atomen, wie z. B. Cyclopentyl, Cyclohexyl, Phenyl oder Benzyl ; Hydroxyl, Carboxyl, CN, Halogen, wie F, Cl oder Br, und Aminogruppen, besonders tertiäre Aminogruppen, die mit Alkylhalogeniden, wie Methylchlorid, -bromid oder -jodid, quaternisiert sein können. Beispiele für Aminogruppen sind Methylamino, Aethylamino, Dimethylamino, Diäthylamino, Pyrrolidyl, Piperidyl, Piperazyl, Morpholyl und N-Methylpiperazyl ; Alkoxycarbonyl mit bevorzugt 1 bis 18, besonders 1 bis 6 C-Atomen in der Alkoxygruppe, Aminocarbonyl mit ein oder zwei Alkylgruppen mit 1 bis 12 C-Atomen in der Aminogruppe, oder Aminocarbonyl mit heterocyclischen Aminen, wie Pyrrolidin, Piperidin, Piperazin, N-Methylpiperazin und Morpholin ; Aminoalkyl, besonders tertiäres Aminoalkyl mit bevorzugt $C_1$-$C_6$-Alkylgruppen, das mit Alkylhalogeniden quaternisiert sein kann. Bevorzugt ist Tertiäraminomethyl, das durch Alkyl mit 1 bis 6 C-Atomen substituiert sein kann. Beispiele sind Dimethylaminomethyl und (Trimethylammonium-methyl) jodid.

Stellt $R^3$ Alkinyl dar, so handelt es sich z. B. um 2-Butinyl und vor allem um Propargyl.

Substituenten für $R^3$ als Phenylalkinyl sind z. B. Halogen, wie F, Cl und Br, Alkyl und Alkoxy mit 1-6 C-Atomen, —CCOH, —OH und —CN. $R^3$ hat bevorzugt die Bedeutung von $R^2$.

In einer bevorzugten Ausführungsform sind $R^2$ und $R^3$ in Formel II unsubstituiertes oder substituiertes 2,6-Difluorphen-1-yl oder $R^2$ und $R^3$ bilden zusammen einen Rest der Formel XI

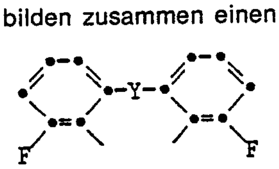 (XI)

worin Y die oben angegebene Bedeutung hat und insbesondere eine direkte Bindung, $CH_2$ oder O ist.

Eine bevorzugte Gruppe von Metallocenen der Formel II sind solche, worin beide $R^1$ $\pi$-Cyclopentadienyl oder durch $C_1$-$C_4$-Alkyl, besonders Methyl, substituiertes $\pi$-Cyclopentadienyl und $R^2$ und $R^3$ je ein Rest der Formel XII

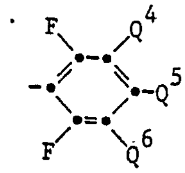

(XII)

sind, worin $Q^4$, $Q^5$ und $Q^6$ unabhängig voneinander für ein Wasserstoffatom, F, Cl, Br oder eine tertiäre Aminogruppe, besonders eine Morpholinogruppe, stehen. Die Aminogruppe ist bevorzugt in para-Stellung zur freien Bindung gebunden. Eine bevorzugte Untergruppe sind Metallocene der Formel II, worin beide $R^1$ $\pi$-Methylcyclopentadienyl und vor allem $\pi$-Cyclopentadienyl darstellen und $R^2$ und $R^3$ je ein Rest der Formel XII sind, worin $Q^4$ und $Q^6$ für H, F, Cl oder Br und $Q^5$ für H oder F stehen. Besonders bevorzugt sind $Q^4$, $Q^5$ und $Q^6$ unabhängig voneinander ein Wasserstoff- oder Fluoratom. Ganz besonders bevorzugt sind $Q^4$, $Q^5$ und $Q^6$ je Fluor.

Als Komponente (c) kommen z. B. definitionsgemässe Aether und vor allem Ester und Teilester von (Meth)Acrylsäure und aromatischen und besonders aliphatischen Polyolen mit insbesondere 2-30 C-Atomen oder cycloaliphatischen Polyolen mit bevorzugt 5 oder 6 Ringkohlenstoffatomen in Betracht. Diese Polyole können auch mit Epoxiden, wie Aethylenoxid oder Propylenoxid, modifiziert sein. Ferner sind auch die Teilester und Ester von Polyoxaalkylenglykolen geeignet. Beispiele für Komponenten (c) sind die folgenden : Aethylenglykoldimethacrylat, Diäthylenglykoldimethacrylat, Triäthylenglykoldimethacrylat, Tetraäthylenglykoldimethacrylat, Polyäthylenglykoldimethacrylate mit einem mittleren Molekulargewicht im Bereich von 200-2 000, Aethylenglykoldiacrylat, Diäthylenglykoldiacrylat, Triäthylenglykoldiacrylat, Tetraäthylenglykoldiacrylat, Polyäthylenglykoldiacrylate mit einem mittleren Molekulargewicht im Bereich von 200-2 000, Trimethylolpropanäthoxylattrimethacrylat, Trimethylolpropanpolyäthoxylattrimethacrylate mit einem mittleren Molekulargewicht im Bereich von 500-1 500, Trimethylolpropanäthoxylattriacrylate mit einem mittleren Molekulargewicht von 500-1 500, Pentaerythritdiacrylat, Pentaerythrittriacrylat, Pentaerythrittetraacrylat, Dipentaerythritdiacrylat, Dipentaerythrittriacrylat, Dipentaerythrittetraacrylat, Dipentaerythritpentaacrylat, Dipentaerythrithexaacrylat, Tripentaerythritoctaacrylat, Pentaerythritdimethacrylat, Pentaerythrittrimethacrylat, Dipentaerythritdimethacrylat, Dipentaerythrittetramethacrylat, Tripentaerythritoctamethacrylat, 1,3-Butandioldimethacrylat, Sorbittriacrylat, Sorbittetraacrylat, Sorbittetramethylacrylat, Sorbitpentaacrylat, Sorbithexaacrylat, Oligoesteracrylate, Oligoestermethacrylate, Glyzerindi- und -triacrylat, 1,4-Cyclohexandiacrylat, Bisacrylate und Bismethacrylate von Polyäthylenglykolen mit einem mittleren Molekulargewicht von 100-1 500, Aethylenglykoldiallyläther, 1,1,1-Trimethylolpropantriallyläther, Pentaerythrittriallyläther, Bernsteinsäure- und Adipinsäurediallylester oder Gemische der genannten Verbindungen.

Die erfindungsgemässe Zusammensetzung kann weitere übliche Zuschlagstoffe enthalten, z. B. Stabilisatoren, insbesondere Inhibitoren für die thermische Polymerisation, wie Thiodiphenylamin und Alkylphenole, z. B. 4-Tertiärbutylphenol, 2,5-Ditertiärbutylhydrochinon oder 2,6-Di-tert.-butyl-4-methylphenol. Weitere geeignete Initiatoren und Sensibilisatoren sind z. B. aromatische Ketone, wie Tetramethyldiaminobenzophenon, Benzophenon, Michler's Keton, [4,4'-Bis(dimethylamino)benzophenon], 4,4'-Bis(diäthylamino)benzophenon, 4-Acryloxy-4'-diäthylaminobenzophenon, 4-Methoxy-4'-dimethylaminobenzophenon, 2-Aethylanthrachinon, Phenanthrachinon, 2-t-Butylanthrachinon, 1,2-Benzanthrachinon, 2,3-Benzanthrachinon, 2,3-Dichlornaphthochinon, Benzyldimethylketal und andere aromatische Ketone, z. B. gemäss US-Patent 3 552 973 ; Benzoin, Benzoinäther, wie Benzoinmethyläther, Benzoinäthyläther, Benzoinisobutyläther und Benzoinphenyläther, Methylbenzoin, Aethylbenzoin und andere Benzoine ; p-Maleinimidobenzolsulfonsäureazid, Thioxanthonderivate, wie Thioxanthon, 2-Chlorthioxanthon, 2-Isopropylthioxanthon, Thioxanthon-1-carbonsäureäthylester, 3-Methoxythioxanthon-1-carbonsäureäthylester in Verbindung mit aromatischen Aminen, wie p-Dimethylaminobenzoesäureäthylester und 4,4'-Bis(dimethylamino)benzophenon, Bisazide wie 2,6-(4'-Azidobenzyliden-4)-methylcyclohexan-1-on. Weitere Zusätze sind Lösungsmittel, die allein oder in Kombinationen verwendet werden können, wie N-Methylpyrrolidon, Butyrolacton, Aethylenglykol-monoäthyläther, Dimethylformamid, Dimethylacetamid und Hexamethylphosphorsäuretriamid ; Pigmente, Farbstoffe, Füllstoffe, Haftmittel, Netzmittel und Weichmacher, sowie Farbstoffe, die durch ihre Eigenabsorption die spektrale Empfindlichkeit der Mischungen beeinflussen können.

Die Herstellung der erfindungsgemässen Zusammensetzungen erfolgt durch Vermischen der Komponenten in hierfür üblichen Einrichtungen.

Die erfindungsgemässen Zusammenzetzungen eignen sich hervorragend als Beschichtungsmittel für Substrate aller Art, z. B. Keramik, Metalle, wie Kupfer und Aluminium, Halbmetalle und Halbleitermaterialien, wie Silicium, Germanium, GaAs, $SiO_2$ und $Si_3N_4$-Schichten, bei denen durch Photopolymerisation eine Schutzschicht oder eine photographische Abbildung aufgebracht werden soll. Ein weiterer Gegenstand vorliegender Erfindung sind die beschichteten Substrate und ein Verfahren zum Aufbringen photographischer Abbildungen, vor allem Reliefabbildungen, auf den Substraten.

Die Herstellung der beschichteten Substrate kann z. B. erfolgen, indem man eine Lösung oder Suspension der Zusammensetzung herstellt. Die Wahl des Lösungsmittels und die Konzentration richtet sich hauptsächlich nach der Art der Zusammensetzung und nach dem Beschichtungsverfahren. Die

Lösung wird mittels bekannten Beschichtungsverfahren gleichförmig auf ein Substrat aufgebracht, z. B. durch Aufschleudern, Tauchen, Rakelbeschichtung, Vorhanggiessverfahren, Aufpinseln, Sprühen und Reverse-roll-Beschichtung. Die Auftragsmenge (Schichtdicke) und Art des Substrates (Schichtträger) sind abhängig vom gewünschten Applikationsgebiet. Für Offsetdruckformen dienen z. B. speziell behandeltes Aluminium und für die Herstellung gedruckter Schaltungen kupferkaschierte Laminate. Die Schichtdicken für photographische Materialien und Offsetdruckformen betragen zweckmässig etwa 0,1 bis ca. 500 μm ; für gedruckte Schaltungen 1 bis ca. 100 μm.

Die Photopolymerisation von (Meth)acrylaten und ähnlichen olefinischen ungesättigten Verbindungen wird bekanntlich durch Luftsauerstoff gehemmt, besonders in dünnen Schichten. Dieser Effekt lässt sich mit bekannten üblichen Methoden, wie z. B. Aufbringen einer temporären Deckschicht aus Polyvinylalkohol oder durch Vorbelichten oder Vorkonditionieren unter Inertgas, vermindern.

Nach dem Beschichten wird das Lösungsmittel durch Trocknen entfernt und es resultiert eine Schicht des lichtempfindlichen Polymers auf dem Träger. Nach der in üblicher Weise erfolgten bildmässigen Belichtung des Materials durch eine Photomaske werden die unbelichteten Stellen des Polymers durch Herauslösen in einem Entwickler (Lösungsmittel) entfernt und das Polymerrelief, bestehend aus vernetztem erfindungsgemässem Polymer, freigelegt. Geeignete Entwickler sind z. B. Lösungsmittel oder Gemische von Lösungsmitteln wie N-Methylpyrrolidon, N-Acetylpyrrolidon, 4-Butyrolacton, Aethylenglykolmonomethyläther, Dimethylformamid, Dimethylacetamid, Dimethylsulfoxid und Cyclohexanon mit Nichtlösungsmitteln, wie Toluol, Xylol, Aethanol, Methanol oder Aceton.

Die Lichtempflindlichkeit der erfindungsgemässen Materialien reicht vom UV-Gebiet (200 nm) bis ca. 600 nm und umspannt somit einen sehr breiten Bereich. Als Lichtquellen kommen daher eine grosse Anzahl der verschiedensten Typen zur Anwendung. Es sind sowohl Punktlichtquellen als auch flächenförmige Strahler (Lampenteppiche) geeignet. Beispiele sind : Kohlelichtbogenlampen, Xenon-Lichtbogenlampen, Quecksilberdampflampen, gegebenenfalls mit Metall-Halogeniden dotiert (Metall-Halogenlampen), Fluoreszenzlampen, Argonglühlampen, Elektronenblitzlampen und photographische Flutlichtlampen. Insbesondere eignen sich Lampen, die im Spektralbereich von 400-480 nm eine vergleichsweise hohe Strahlungsintensität besitzen. Der Abstand zwischen Lampe und erfindungsgemässem Bildmaterial kann je nach Anwendungszweck und Lampentyp bzw. -stärke variieren, z. B. zwischen 2 cm bis 150 cm. Geeignet sind auch Laserlichtquellen, z. B. Argonionenlaser oder Kryptonionenlaser mit starken Emissionslinien (Ar-Laser) bei 457, 476, 488, 514, 528 nm. Bei dieser Art der Belichtung ist keine Photomaske im Kontakt mit der Photopolymerschicht mehr nötig ; der gesteuerte Laser-Strahl schreibt direkt auf die Schicht. Hier ist die hohe Empfindlichkeit der erfindungsgemäss verwendeten Materialien sehr vorteilhaft, die hohe Schreibgeschwindigkeiten bei relativ niedrigen Intensitäten erlaubt. Nach dieser Methode können gedruckte Schaltungen in der Elektronikindustrie, lithographische Offsetdruckplatten oder Reliefdruckplatten sowie photographische Bildaufzeichnungsmaterialien hergestellt werden.

Die wichtigsten Anwendungen sind die Verwendung als Aetzresist, Galvanoresist und Lötstopplack bei der Herstellung von gedruckten Schaltungen und Druckplatten, die Herstellung von Photopolymerdruckplatten für den Offsetdruck, Buchdruck (Hochdruck), sowie beim Flexodruck und Siebdruck als Abdecklack und zur Herstellung von photographischen Bildaufzeichnungsmaterialien, z. B. gemäss DE-A-26 51 864 oder DE-A-22 02 360.

Hauptanwendung ist die Herstellung von hitze- und chemikalienbeständigen Reliefstrukturen von z. B. etwa 0,05 bis 500 μm Schichtstärke auf elektronischen Bauteilen, wie Kondensatoren, diskreten Halbleitern, integrierten Schaltkreisen, Hybridschaltungen, Leiterplatten, Flüssigkristallanzeigen und Photosensoren. Insbesondere eignen sich die Zusammensetzungen für den Einsatz auf aktiven Bauelementen, so als Passivierschutz, besonders als α-Strahlenschutz für Speicherbausteine (relativ dicke Schichten) oder als Dielektrikum für Mehrlagen-Schaltungen (dünnere Schichten). Für diese Anwendung werden die beschichteten und gegebenenfalls bildmässig belichteten und entwickelten Materialien zu bei hohen Temperaturen beständigen Abbildungen getempert, vorzugsweise bei Temperaturen zwischen 300 und 400 °C, wobei die Umwandlung in Ringstrukturen erfolgt und flüchtige Anteile entfernt werden.

Die erfindungsgemäss zu verwendenden Zusammensetzungen zeichnen sich durch eine hohe Lichtempflindlichkeit über einen breiten Absorptionsbereich bis zum sichtbaren Licht aus, so dass auch dickere Schichten problemlos und wirtschaftlich in Strukturen modifiziert werden können. Es wird eine hohe Auflösung (bis ca. 1 μm) und eine hohe Kantenschärfe erzielt. Ferner wird ein geringerer Schichtdickenabtrag beobachtet und es werden bei geringerer Lichtleistung naturgetreue Abbildungen erzielt.

Die nachfolgenden Beispiele erläutern die Erfindung näher.

## Beispiel 1

Es werden die folgenden Komponenten verwendet : Polyamidsäureester (Polymer-Vorstufe Nr. 1) aus wiederkehrenden Strukturelementen der Formel

(Siehe Formel Seite 16 f.)

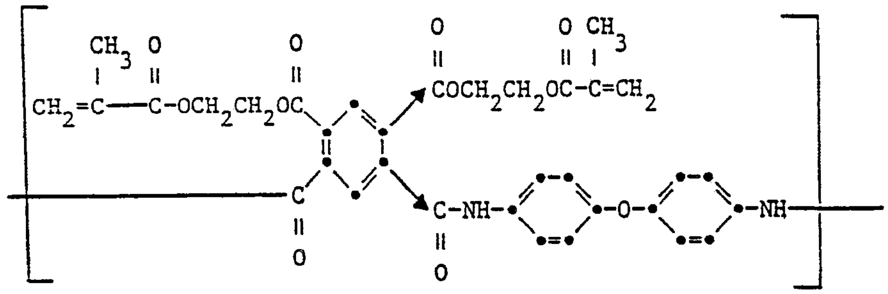

| | |
|---|---|
| ($\overline{M}_w$ = 14'000) | 31 |
| N-Methylpyrrolidon (NMP) | 69 g |
| Di-π-cyclopentadienyl-Ti-bis-(2,3,4,5,6-pentafluorphen-1-yl)[$(Cp)_2Ti(C_6F_5)_2$](Photoinitiator Nr. 1) | 1,55 g |
| Tetraäthylenglykoldimethacrylat | 3,1 g |
| Orasolblau | 0,4 g |

Die Komponenten werden vereinigt und gelöst und mittels einer Rakel-Beschichtungsmaschine auf Aluminiumsubstrate aufgebracht (Schichtstärke der ungetrockneten Schicht ca. 12 μm). Nach 10 Minuten Trocknung im Umluftofen bei 70 °C erfolgt die Belichtung mittels einer Halogen-Metalldampflampe. Die Entwicklung erfolgt für 22 sec. in einem Tauchbad von Toluol und 4-Butyrolacton im Verhältnis 1 : 1 bei einer Temperatur von 23 °C. Bei einer Lampenleistung von 37,5 mW/cm² und einer Substrattemperatur nahe 23 °C wird eine Belichtungszeit von nur 1 sec. benötigt, um mittels eines Stouffer-Graukeils 2-3 Stufen zu erzeugen.

Beispiel 2

| | |
|---|---|
| Polymer-Vorstufe Nr. 2 (wie Beispiel 1, aber $\overline{M}_w$ = 19'000) | 31 g |
| NMP | 69 g |
| $(Cp)_2Ti(C_6F_5)_2$ | 0,93 g |
| Tetraäthylenglykoldimethacrylat | 4,65 g |
| Vinyltris(2-methoxyäthoxy)silan | 0,31 g |

Die fertige Lösung wird durch einen 1,2 μm Teflon-Absolutfilter gefiltert und bei 4 000 U/min für 20 sec. auf mit $SiO_2$ beschichtete Siliciumwafer aufgeschleudert. Getrocknet wird für 10 min. bei 70 °C im Umluftofen. Die Belichtung erfolgt mit einer Quecksilberhöchstdrucklampe im Vakuumkontakt mit zusätzlicher Stickstoff-Spülung bei einer Substrattemperatur von 23 °C.

Entwickelt wird durch Aufsprühen einer Mischung von Toluol und 4-Butyrolacton im Verhältnis 2 : 1 in einem Sprühentwickler (2 bar Druck) nach folgendem Programm :

| | |
|---|---|
| 1. Toluol : Butyrolacton 2 : 1 | 5 sec. |
| 2. Toluol : Butyrolacton 5 : 1 | 3 sec. |
| 3. Toluol | 3 sec. |

Zur genauen Bestimmung der Belichtungszeit wird eine Schwarzchrommaske mit Teststrukturen der Grösse 1 μm, 2 μm, 3 μm ... 10 μm, 20 μm ... 100 μm verwendet. Als Belichtungszeit wird diejenige Zeit herangezogen, bei der eine ausreichend gute 1 : 1-Abbildung aller Strukturen (Gräben und Stege) grösser als das Zweifache der Schichtstärke zu beobachten ist. Bei einer Lichtleistung von 6,45 mW/cm² wird eine Belichtungszeit von nur 18 sec. (entspricht 116 mJ/cm²) benötigt. Die Schichtstärke beträgt 2,10 μm und die Strukturen der Grösse 3 μm sind noch gut aufgelöst. Auch bei einer Belichtungszeit von nur 5 sec. sind noch scharf definierte Reliefstrukturen zu beobachten.

Die erhaltenen Reliefstrukturen werden dann in einen Ofen gebracht, innert 30 min. auf 275 °C erwärmt, dort für weitere 30 min. belassen und dann innerhalb 45 min. auf eine Endtemperatur von 400 °C erhitzt. Die umgewandelten scharf definierten Reliefstrukturen haben eine Schichtstärke von 1,10 μm.

Beispiel 3

| | |
|---|---|
| Polymer-Vorstufe Nr. 1 ($\overline{M}_w$ = 14'000) | 45 g |
| NMP | 55 g |
| $(Cp)_2Ti(C_6F_5)_2$ | 1,35 g |
| Tetraäthylenglykoldimethacrylat | 6,75 g |
| Vinyltris(2-methoxyäthoxy)silan | 0,45 g |

Die fertige Lösung wird durch ein 2,7 µm-Filter gefiltert und bei 800 U/min. auf eine mit $SiO_2$ beschichtete Wafer aufgeschleudert. Getrocknet wird für 3,5 h bei 70 °C im Umluftofen. Belichtet wird im Vakummkontakt mittels einer Maske.

Die Entwicklung erfolgt im Sprühentwickler durch Aufsprühen einer Mischung von Toluol und 4-Butyrolacton im Verhältnis 2 : 1 nach folgendem Programm (2 bar Druck) :

| | |
|---|---|
| 1. Toluol : Butyrolacton 2 : 1 | 90 sec. |
| 2. Toluol : Butyrolacton 5 : 1 | 3 sec. |
| 3. Toluol | 8 sec. |

Bei einer Lichtleistung von 27,8 $mW/cm^2$ wird eine Belichtungszeit von 50 sec. benötigt, um scharfe Strukturen einer Schichtstärke von 62 µm mit einer glatten Oberfläche zu erzeugen. Die Kanten sind sehr scharf ausgebildet und es wird keinerlei Unterlösung der Strukturen beobachtet. Die erhaltenen Reliefstrukturen werden darauf nach folgendem Temperprogramm ausgehärtet : Aufheizen auf 400 °C innerhalb 3,5 h und Belassen bei dieser Temperatur für 30 min. Die Endschichtstärke beträgt 38 µm.

Beispiele 4-6

Es wird wie in Beispiel 2 verfahren. Die Ergebnisse sind in nachfolgender Tabelle I zusammengefasst, wobei die Ergebnisse für Beispiel 2 mitaufgeführt sind. Die Lichtleistung wird mit Hilfe eines Intensitätsmessgerätes (OAI Power Meter Modell 206) der Firma Optical Associates Inc. bestimmt ; alle Angaben beziehen sich auf die Messsonde von 365 nm. Die Schichtdicken werden mittels eines Profilometers (Alpha-Step) der Firma Tencor bestimmt.

(Siehe Tabelle I Seite 18 f.)

Tabelle I

| Beispiel Nr. | Photoinitiator | Gew. % | Acrylat/ Methacrylat | Gew. % | Belichtungszeit (sec) | Schichtstärke nach dem Entwickeln (μm) | Schichtstärke nach thermischer *** Belastung (μm) | Lichtleistung ($mJ/cm^2$) |
|---|---|---|---|---|---|---|---|---|
| 4 | $(Cp)_2Ti(C_6F_5)_2$ | 3 | TMPTA* | 15 | 38 | 2,10 | 1,20 | 245,1 |
| 5 | $(Cp)_2Ti(C_6F_5)_2$ | 5 | TMPTA | 20 | 21 | 2,20 | 1,15 | 135,5 |
| 2 | $(Cp)_2Ti(C_6F_5)_2$ | 3 | TGDM** | 15 | 18 | 2,10 | 1,10 | 116,1 |
| 6 | $(Cp)_2Ti(C_6F_5)_2$ | 5 | TGDM | 20 | 11 | 2,10 | 1,05 | 70,0 |

* Trimethylolpropantriacrylat
** Tetraäthylenglykoldimethacrylat
Cp = π-Cyclopentadienyl
*** entsprechend Beispiel 2

Beispiele 7-15 : (Tabelle II)

Es wird wie in Beispiel 2 bzw. Beispiel 3 verfahren unter Verwendung von Di-π-methylcyclopentadienyl-Ti-bis(2,3,4,5,6-pentafluorphen-1-yl) $[(CH_3\text{-}Cp)_2Ti(C_6F_5)_2]$ (Photoinitiator Nr. 2) und verschiedenen Komponenten (c) sowie der folgenden Polymer-Vorstufe :

Polymer-Vorstufe Nr. 3, wie Polymer-Vorstufe Nr. 1 aber mit einem Molekulargewicht ($\overline{M}_w$) von 10 000. Der Photoinitiator wird jeweils in einer Menge von 3 Gew.-%, bezogen auf die Polymer-Vorstufe, eingesetzt.

Beispiele 16-25 : (Tabelle III)

Es wird wie in Beispiel 3 verfahren unter Verwendung der Polymer-Vorstufe Nr. 3, 10 Gew.% Tetraäthylenglykoldimethacrylat und jeweils 3 Gew.% weiterer verschiedener Photoinitiatoren, bezogen auf die Polymer-Vorstufe.

(Siehe Tabellen Seite 20 ff.)

Tabelle II

| Beispiel Nr. | Komponente (c) | Gew.% | Schichtstärke nach dem Entwickeln [µm] | Schichtstärke * nach thermischer Belastung [µm] | Lichtleistung ($mJ/cm^2$) |
|---|---|---|---|---|---|
| 7 | keine | - | 1,70 | 0,94 | 6500 |
| 8 | 1,1,1-Trimethylolpropantriacrylat | 15 | 2,12 | 1,21 | 990 |
| 9 | Tetraäthylenglykoldimethacrylat | 15 | 1,65 | 0,84 | 470 |
| 10 | keine | - | 70,5 | 43,6 | 12 000 |
| 11 | Tetraäthylenglykoldimethacrylat | 10 | 68,8 | 41,6 | 3000 |
| 12 | Tetraäthylenglykoldimethacrylat | 15 | 66,5 | 39,2 | 1800 |
| 13 | Polyäthylenglykol-200-dimethacrylat | 15 | 76,2 | 44,2 | 1500 |
| 14 | Polyäthylenglykol-400-diacrylat | 15 | 68,3 | 39,1 | 1200 |
| 15 | Pentaerythrittriallyläther | 15 | 69,1 | 40,8 | 3200 |

* entsprechend Beispiel 2 bzw. Beispiel 3

Tabelle III

| Beispiel Nr. | Photoinitiator Nr. | Chemische Struktur | Schichtstärke nach dem Entwickeln [µm] | Schichtstärke nach thermischer Belastung [µm] | Belichtungszeit [sec] bei 30 mW/$cm^2$ | Lichtleistung ($mJ/cm^2$) |
|---|---|---|---|---|---|---|
| 16 | 1 | $(Cp)_2Ti$ 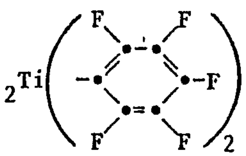 | 61,3 | 39,2 | 120 | 3600 |
| 17 | 2 | $(Methyl\text{-}Cp)_2Ti$ 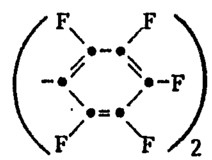 | 68,8 | 41,6 | 100 | 3000 |
| 18 | 3 | $(Cp)_2Ti$ 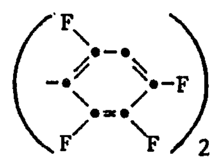 | 68,2 | 41,4 | 45 | 1350 |
| 19 | 4 | $(Cp)_2Ti$ 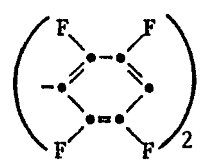 | 64,7 | 39,5 | 75 | 2250 |

Tabelle III (Fortsetzung)

| Beispiel Nr. | Photoinitiator Nr. | Chemische Struktur | Schichtstärke nach dem Entwickeln [µm] | Schichtstärke nach thermischer Belastung [µm] | Belichtungszeit [sec] bei 30 $mW/cm^2$ | Lichtleistung ($mJ/cm^2$) |
|---|---|---|---|---|---|---|
| 20 | 5 | $(Methyl\text{-}Cp)_2Ti$ 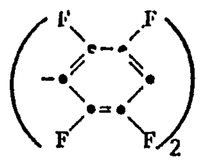 | 68,0 | 40,4 | 250 | 7500 |
| 21 | 6 | $(Cp)_2Ti$ 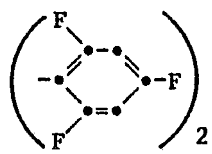 | 70,1 | 41,0 | 45 | 1350 |
| 22 | 7 | $(Methyl\text{-}Cp)_2Ti$ 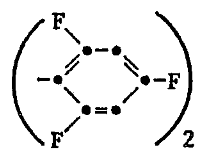 | 62,4 | 38,0 | 100 | 3000 |
| 23 | 8 | $(Methyl\ \text{-}Cp)_2Ti$ 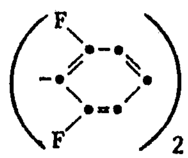 | 69,5 | 41,6 | 70 | 2100 |

Tabelle III (Fortsetzung)

| Beispiel Nr. | Photoinitiator Nr. | Chemische Struktur | Schichtstärke nach dem Entwickeln [µm] | Schichtstärke nach thermischer Belastung [µm] | Belichtungszeit [sec] bei 30 mW/$cm^2$ | Lichtleistung ($mJ/cm^2$) |
|---|---|---|---|---|---|---|
| 24 | 9 | $(Cp)_2Ti$ 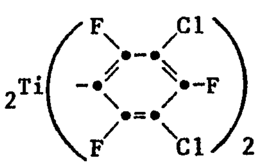 | 65,0 | 39,5 | 900 | 27000 |
| 25 | 10 | $(Cp)_2Ti$ 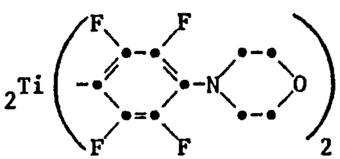 | 65,6 | 39,6 | 325 | 9750 |

Aus den Tabellen I-III ist ersichtlich, dass mit Polymer-Vorstufen, die ein Molekulargewicht im Bereich von etwa 10 000 bis 50 000 aufweisen, höhere Molekulargewichte im allgemeinen eine höhere Lichtempfindlichkeit ergeben. Ebenso bewirkt die Mitverwendung von Komponenten (c), vor allem von Acrylaten und Methacrylaten, eine Erhöhung der Lichtempfindlichkeit. Schliesslich geht aus den Tabellen I-III auch hervor, dass sich erfindungsgemäss auch hohe Schichtdecken mit kurzen Belichtungszeiten photopolymerisieren lassen. Insbesondere gilt auch, dass bei zunehmender Schichtdicke die benötigte Belichtungsenergie vergleichsweise nur relativ wenig ansteigt.

Beispiele 26-38 (Tabelle IV)

Es wird wie in Beispiel 2 bzw. Beispiel 3 verfahren unter Verwendung verschiedener Photoinitiatoren und Komponenten (c) sowie der folgenden Polymer-Vorstufen und Polymer-Vorstufe Nr. 1.

Polymer-Vorstufe Nr. 4 ($\bar{M}_w$ = 11'000) aus wiederkehrenden Strukturelementen der Formel

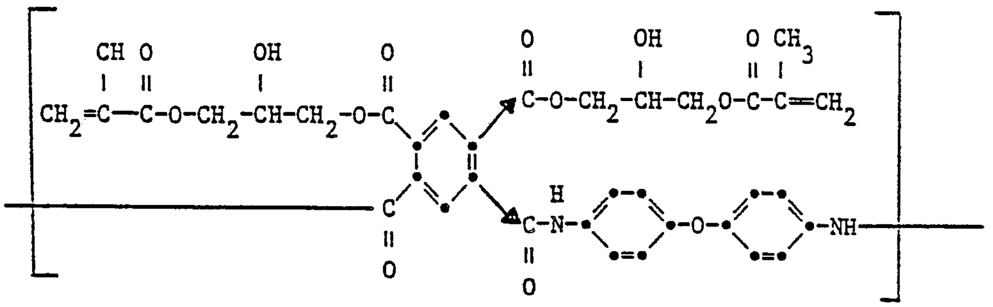

hergestellt analog dem in der europäischen Patentveröffentlichung Nr. 84264 beschriebenen Verfahren.

Polymer-Vorstufe Nr. 5 ($\bar{M}_w$ = 12'000) aus wiederkehrenden Strukturelementen der Formel

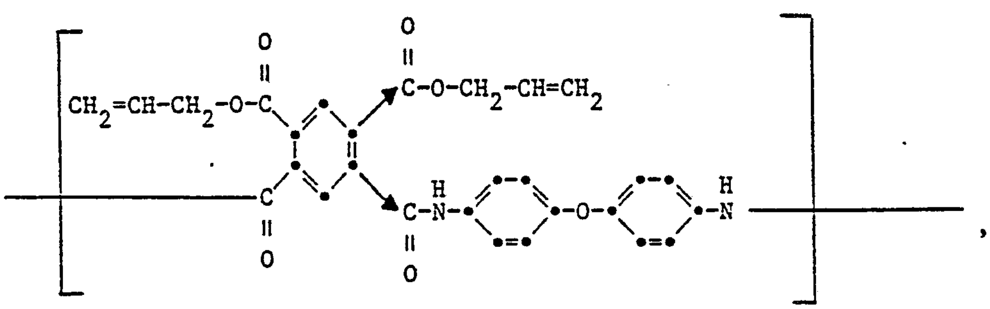

hergestellt nach dem in der DE-OS 2 308 830 beschriebenen Verfahren.

Polymer-Vorstufe Nr. 6 aus wiederkehrenden Strukturelementen der Formel

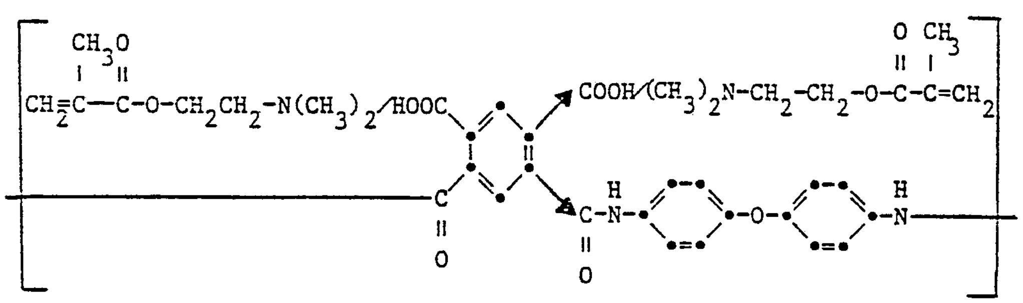

hergestellt durch Vermischen der entsprechenden Polyamidsäure (aus 4,4'-Diaminodiphenyläther und Pyrromellitsäuredianhydrid) mit 2-(N,N-Dimethylamino) äthylmethacrylat (vergl. z. B. europäische Patentveröffentlichung Nr. 65352).

Polymer-Vorstufe Nr. 7 aus wiederkehrenden Strukturelementen der Formel

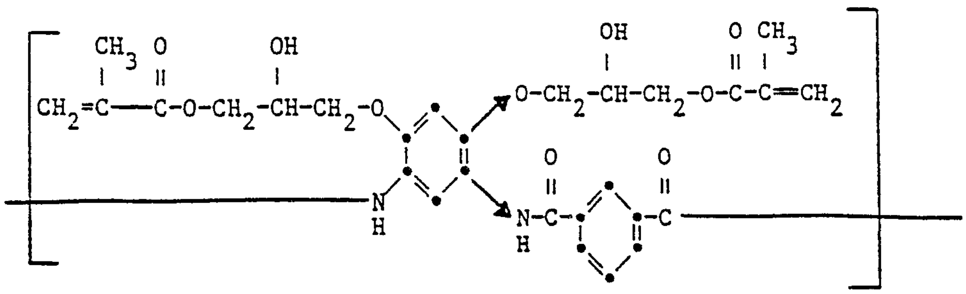

hergestellt analog dem in der DE-OS 2 933 805 beschriebenen Verfahren.

Polymer-Vorstufe Nr. 8 aus wiederkehrenden Strukturelementen der Formel

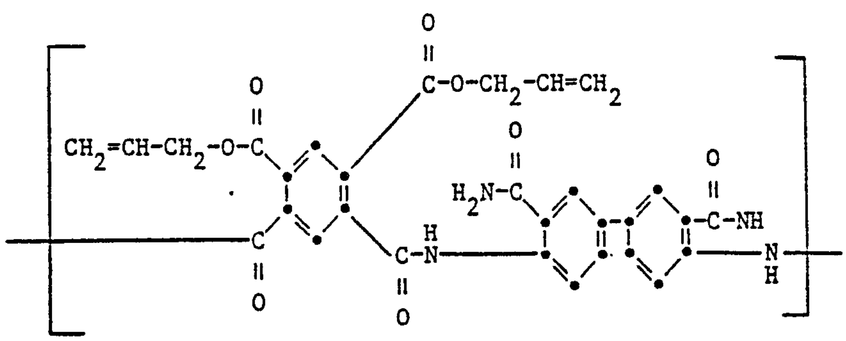

hergestellt analog dem in den DE-OS 2 308 830 und 2 437 397 beschriebenen Verfahren.

Die Ergebnisse und die weiteren Verarbeitungsbedingungen sind in Tabelle IV zusammengefasst.

(Siehe Tabelle IV Seite 26 ff.)

Tabelle IV

| Beispiel Nr. | Polymer-Vorstufe Nr. | Photoinitiator Nr. | Gew.% | Komponente (c) | Gew.% | Entwickler*) | Schichtstärke nach dem Entwickeln (µm) | Schichtstärke nach thermischer Belastung [µm] | Lichtleistung $mJ/cm^2$ |
|---|---|---|---|---|---|---|---|---|---|
| 26 | 4 | 2 | 3 | keine | - | DMA/GBL 1:1 | 1,30 | 0,66 | 3000 |
| 27 | 4 | 2 | 3 | Tetraäthylenglykoldimethacrylat | 15 | DMA/GBL 1:1 | 1,25 | 0,72 | 148 |
| 28 | 4 | 2 | 3 | Tetraäthylenglykoldimethacrylat | 15 | DMA/GBL 1:1 | 40,5 | 21,5 | 495 |
| 29 | 5 | 2 | 3 | Tetraäthylenglykoldimethacrylat | 15 | DMF/Toluol 1:2 | 0,80 | 0,46 | 420 |
| 30 | 6 | 2 | 3 | keine | - | DMF/Toluol 1:1,1 | 1,34 | 0,87 | 1200 |
| 31 | 6 | 2 | 3 | Tetraäthylenglykoldimethacrylat | 15 | DMF/Toluol 1:1,1 | 1,01 | 0,71 | 480 |
| 32 | 6 | 3 | 7 | keine | - | DMF/Toluol 1:0,55 | 20,5 | 12,8 | 5700 |
| 33 | 6 | 3 | 7 | Polyäthylglykol-400-dimethacrylat | 10 | DMF/Toluol 1:0,55 | 13,5 | 6,4 | 4800 |

*) Volumenverhältnisse

Tabelle IV (Fortsetzung)

| Beispiel Nr. | Polymer-Vorstufen Nr. | Photoinitiator Nr. | Gew.% | Komponente (c) | Gew.% | Entwickler | Schichtstärke nach dem Entwickeln (µm) | Schichtstärke nach thermischer Belastung [µm] | Lichtleistung $mJ/cm^2$ |
|---|---|---|---|---|---|---|---|---|---|
| 34 | 7 | 2 | 3 | Tetraäthylenglykoldimethacrylat | 15 | NMP/Aethanol 1:5 | 8,3 | 4,2 | 480 |
| 35 | 8 | 2 | 3 | Tetraäthylenglykoldimethacrylat | 15 | Dioxan/DMA 4:1 | 27,5 | 16,7 | 720 |
| 36 | 1 | 3 | 3 | Tetraäthylglykoldimethacrylat | 15 | GBL/Toluol 1:1 | 65,8 | 40,1 | 370 |
| 37 | 1 | 3 | 3 | Tetraäthylglykoldiacrylat | 15 | GBL/Toluol 1:1 | 67,1 | 40,6 | 250 |
| 38 | 1 | 3 | 3 | Tetraäthylglykoldiacrylat | 15 | GBL/Toluol 1:1 | 105 | 64,0 | 350 |

DMA = Dimethylacetamid,
GBL = Butyrolacton,
DMF = Dimethylformamid
NMP = Methylpyrrolidon

Die Metallocene der Formel II können wie folgt hergestellt werden :

10 g (32,5 mMol) 1,4-Dibromtetrafluorbenzol werden in je 100 ml Aether und Tetrahydrofuran unter Argon als Schutzgas gelöst, auf —78° gekühlt und mit 21 ml Lithiumbutyl-Hexanlösung (1,6 molar) versetzt. Nach 15 Minuten werden 6,08 g (65 mMol) N,N-Dimethylmethylenimmoniumchlorid zugegeben und die Mischung auf Raumtemperatur aufgewärmt. Nach 1 1/2 Stunden wird auf Wasser gegossen, mit Aether extrahiert und mit $MgSO_4$ getrocknet. Nach dem Abdestillieren des Lösungsmittels erhält man einen weissen Festkörper, der am Hochvakuum bei 100° destilliert wird. Man erhält 7,8 g (84 %) farbloses, bei Raumtemperatur festes Produkt.

25 g Brompentafluorbenzol werden in 750 ml absolutem Aether gelöst und unter Argon-Schutzgas auf —78° gekühlt. Nach dem Versetzen mit 62,5 ml Lithiumbutyl-Hexan-Lösung (1,6 molar) wird während 15 Minuten bei —78° weitergerührt, 12,5 g $Cp_2TiCl_2$ als Pulver zugegeben und die Kühlung entfernt. Die Mischung wärmt sich innert 2 Stunden auf Raumtemperatur auf. Die orange Suspension wird eingedampft, in Methylenchlorid aufgeschlämmt und filtriert. Durch Zugabe von Hexan zur orangen Lösung wird das orange Produkt ausgefällt. Es resultieren nach dem Trocknen im Hochvakuum bei Raumtemperatur 23,6 g (92 %) $Cp_2Ti(C_6F_5)_2$ in Form oranger Kristalle, die bei 230° unter Zersetzung schmelzen.

Analog werden die in Tabelle III angegebenen Photoinitiatoren hergestellt. Cp bedeutet π-Cyclopentadienyl.

**Patentansprüche**

1. Photopolymerisierbare Zusammensetzung, die neben üblichen Zusätzen

(a) eine Polymer-Vorstufe mit gleichen oder verschiedenen wiederkehrenden Strukturelementen der Formel I

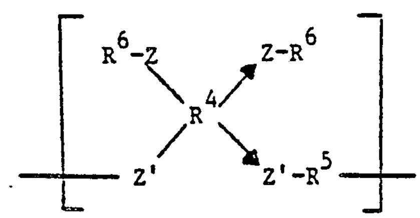

(I)

die beim Erwärmen zu einer thermostabilen Ringstruktur reagiert,

(b) einen Photoinitiator und gegebenenfalls

(c) einen Acrylsäureester, Methacrylsäureester, Allyläther oder Allylester oder Teilester dieser Säuren mit einem Polyol enthält,

dadurch gekennzeichnet, dass der Photoinitiator (b) ein Metallocen der Formel II

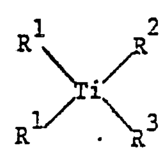

(II)

ist, worin

beide $R^1$ unabhängig voneinander unsubstituiertes oder substituiertes Cyclopentadienyl$^{\ominus}$, Indenyl$^{\ominus}$ oder beide $R^1$ zusammen einen unsubstituierten oder substituierten Rest der Formel III

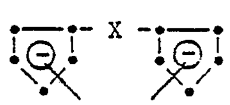

(III)

darstellen,

$R^2$ carbocyclischen oder einen 5- oder 6-gliedrigen heterocyclischen aromatischen Ring bedeutet, der in mindestens einer der beiden Orthostellung zur Metallkohlenstoffbindung durch ein Fluoratom substituiert ist und weitere Substituenten enthalten kann,

$R^3$ $C_{3-5}$-Alkinyl, substituiertes oder unsubstituiertes Phenylalkinyl mit 3-5 Kohlenstoffatomen in der Alkinylgruppe, $N_3$, CN, $Si(R^7)_3$ oder $Sn(R^7)_3$ darstellt oder die Bedeutung von $R^2$ hat oder $R^2$ und $R^3$ zusammen einen Rest der Formel IV

$$—Q—Y—Q— \qquad (IV)$$

bedeuten,

$R^4$ ein vierwertiger aromatischer Rest nach Entfernen von vier funktionellen Gruppen ist, wobei je

zwei funktionelle Gruppen benachbart sind und → für Strukturisomere steht,

$R^5$ einen zweiwertigen aliphatischen, cycloaliphatischen oder ein- oder mehrkernigen aromatischen Rest bedeutet, wobei aromatische Reste $R^5$ in ortho-Stellung zur Bindung an Z' eine Gruppe —$CONH_2$ oder —COOH aufweisen können,

$R^6$ für einen Rest mit einer photopolymerisierbaren olefinischen Doppelbindung steht,

$R^7$ $C_1$-$C_{12}$-Alkyl, $C_5$-$C_{12}$-Cycloalkyl, $C_6$-$C_{16}$-Aryl oder $C_7$-$C_{16}$-Aralkyl bedeutet,

die Z ein kovalentes oder ionisches Bindungsglied und die Z' ein kovalentes Bindungsglied bedeuten, mit der Massgabe, dass Z und Z' beim Erwärmen der photopolymerisierbaren Zusammensetzung unter Abspaltung von $R^6$, gegebenenfalls zusammen mit in $R^5$ enthaltenen Gruppen —$CONH_2$ oder —COOH, eine thermostabile Ringstruktur ergeben,

$X(CH_2)_n$ mit n = 1, 2 oder 3, Alkyliden mit 2-12 C-Atomen, Cycloalkyliden mit 5-7 Ringkohlenstoffatomen, $Si(R^7)_2$ oder $Sn(R^7)_2$ ist,

Q für einen carbocyclischen oder heterocyclischen 5- oder 6-gliedrigen aromatischen Ring steht, wobei die beiden Bindungen jeweils in ortho-Stellung zur Gruppe Y stehen und die meta-Stellung zur Gruppe Y jeweils durch ein Fluoratom substituiert ist und Q weitere Substituenten enthalten kann, und Y $CH_2$, Alkyliden mit 2-12 C-Atomen, Cycloalkyliden mit 5-7 Ringkohlenstoffatomen, eine direkte Bindung, $NR^7$, O, S, SO, $SO_2$, CO, $Si(R^7)_2$ oder $Sn(R^7)_2$ bedeutet.

2. Zusammensetzung nach Anspruch 1, dadurch gekennzeichnet, dass man 50 bis 97,5 Gew.-% der Komponente (a) und 2,5 bis 50 Gew.-% der Komponente (c) enthalten sind, bezogen auf die Komponenten (a) und (c).

3. Zusammensetzung nach Anspruch 1, dadurch gekennzeichnet, dass der Photoinitiator (b) in einer Menge von 0,1 bis 20 Gew.-% zugegen ist, bezogen auf die Komponente (a) oder die Komponente (a) und (c).

4. Zusammensetzung nach Anspruch 1, worin Z —COO—, —CONH—, —O—, —NH—, —$COOH/NR^{14}R^{15}$— oder

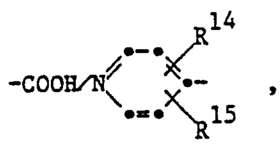 ,

Z' —CONH—, —NHCO—, —NH—CO—NH— oder —O—CO—NH— und $R^{14}$ und $R^{15}$ unabhängig voneinander Alkyl oder Alkenyl mit bis zu 6 C-Atomen bedeuten.

5. Zusammensetzung nach Anspruch 1, worin Z —CONH—, —COO— oder —$COOH/N(CH_3)_2$- und Z' —CONH— bedeuten oder Z —O— und Z' —NHCO— darstellen.

6. Zusammensetzung nach Anspruch 1, worin

$R^4$ einen Rest der Formel V oder VI

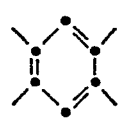 (V) oder 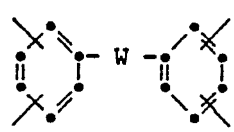 (VI)

$R^5$ einen Rest der Formeln VII, VIII oder IX

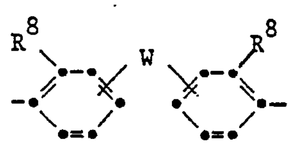 (VII) 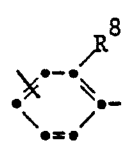 (VIII)

oder

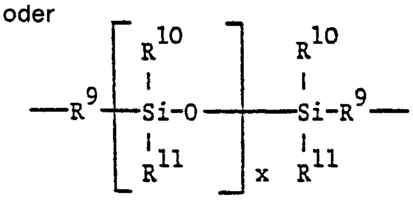 (IX) und

$R^6$ einen Rest der Formel X

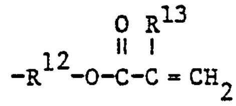 (X)

oder bei Z = —COO— auch —CH = $CH_2$, —$CH_2CH$ = $CH_2$ oder —$CH_2C(CH_3)$ = $CH_2$ darstellen, worin W eine direkte Bindung, O, CO, $CH_2$, $C(CF_3)_2$, S, SO, $SO_2$, NH oder Alkyliden mit 2-12 C-Atomen bedeutet,

x eine ganze Zahl von 1-10, besonders 1-5,

die $R^8$ unabhängig voneinander ein Wasserstoffatom, —$CONH_2$ oder —COOH,

$R^9$ —$C_pH_{2p}$— mit p = 1-5,

$R^{10}$ und $R^{11}$ unabhängig voneinander geradkettiges oder verzeigtes Alkyl mit 1-6 C-Atomen, besonders Methyl,

$R^{12}$ —$C_mH_{2m}$— mit m = 2-12, —$CH_2CH(OH)CH_2$— oder Polyoxaalkylen mit 4-30 C-Atomen und

$R^{13}$ ein Wasserstoffatom oder Methyl bedeuten,

wobei die $R^4$, $R^5$ und $R^6$ in den einzelnen Strukturelementen gleiche oder verschiedene Bedeutungen haben können.

7. Zusammensetzung nach Anspruch 6, worin $R^5$ in 0-100 % der wiederkehrenden Strukturelemente einen Rest der Formel VII und in 100-0 % der wiederkehrenden Strukturelemente einen Rest der Formel VIII darstellt.

8. Zusammensetzung nach Anspruch 6, worin $R^5$ in 70-100 % der wiederkehrenden Strukturelemente einen Rest der Formel VII und/oder VIII und in 30-0 % der wiederkehrenden Strukturelemente einen Rest der Formel IX bedeutet.

9. Zusammensetzung nach Anspruch 1, worin die Polymer-Vorstufe (a) eine solche mit wiederkehrenden Strukturelementen der Formel Ia

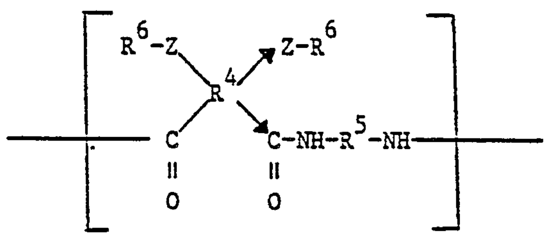

(Ia)

ist, worin $R^4$ der vierwertiger Rest einer aromatischen Tetracarbonsäure nach Entfernen von vier Carboxylgruppen ist und $R^5$, $R^6$ und Z die im Anspruch 1 angegebene Bedeutung haben.

10. Zusammensetzung nach Anspruch 9, worin Z —CO—O— darstellt.

11. Zusammensetzung nach Anspruch 1, worin die Polymer-Vorstufe (a) aus wiederkehrenden Strukturelementen der Formel Ic

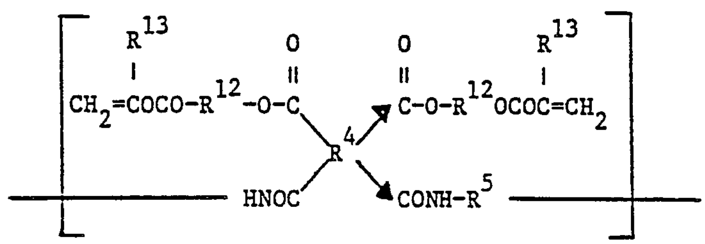

(Ic)

besteht, worin $R^4$ den Rest des Pyromellitsäuredianhydrids, eines Benzophenontetracarbonsäuredianhydrids oder ein Gemisch solcher Reste darstellt, die $R^5$ in den einzelnen wiederkehrenden Strukturelementen unabhängig voneinander 1,3- oder 1,4-Phenylen, den Rest des 4,4'-Diaminodiphenyläthers, 4,4'-Diaminodiphenylmethans, 2,2-Bis-(4,4'-Diaminodiphenyl) hexafluoropropans, 4,4'-Diamino-3-carbonamidodiphenyläthers oder 4,4'-Diamino-3,3'-bis-carbonamidobiphenyls darstellen, $R^{12}$ —$CH_2CH_2$— oder —$CH_2CH(OH)CH_2$— und $R^{13}$ ein Wasserstoffatom oder Methyl bedeuten.

12. Zusammensetzung nach Anspruch 1, worin die Polymer-Vorstufe aus wiederkehrenden Strukturelementen der Formel Id

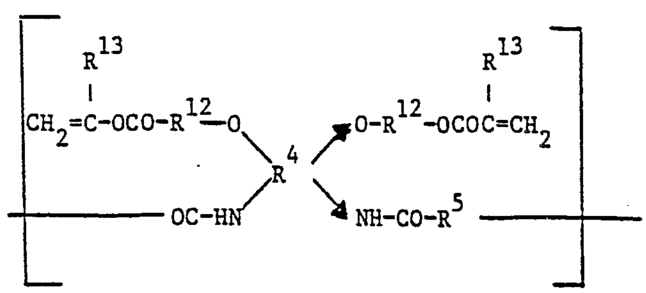

(Id)

besteht, worin $R^4$ den Rest des 3,3'-Dihydroxybenzidins, die $R^5$ in den einzelnen wiederkehrenden Strukturelementen unabhängig voneinander 1,3-Phenylen, oder den Rest der 4,4'-Benzophenondicarbonsäure, $R^{12}$ $-CH_2-CH_2-$, $-CH_2CH_2CH_2-$ oder $-CH_2CH(OH)CH_2-$ und $R^{13}$ ein Wasserstoffatom oder Methyl darstellen.

13. Zusammensetzung nach Anspruch 1, dadurch gekennzeichnet, dass die Komponente (c) ein Ester oder Teilester von (Meth)-Acrylsäure und aliphatischen Polyolen mit 2-30 C-Atomen oder cycloaliphatischen Polyolen mit 5 oder 6 Ringkohlenstoffatomen ist.

14. Zusammensetzung nach Anspruch 1, dadurch gekennzeichnet, dass $R^2$ und $R^3$ in Formel II unsubstituiertes oder substituiertes 2,6-Difluorphen-1-yl oder $R^2$ und $R^3$ zusammen ein Rest der Formel XI

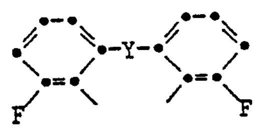

(XI)

sind, worin Y eine direkte Bindung, $CH_2$ oder O bedeutet.

15. Zusammensetzung nach Anspruch 1, worin in Formel II beide $R^1$ unsubstituiertes oder durch $C_1$-$C_4$-Alkyl, besonders Methyl, substituiertes $\pi$-Cyclopentadienyl und $R^2$ und $R^3$ je einen Rest der Formel XII

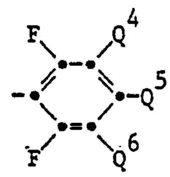

(XII)

bedeuten, worin $Q^4$, $Q^5$ und $Q^6$ unabhängig voneinander für H, F, Cl, Br oder eine tertiäre Aminogruppe stehen.

16. Zusammensetzung nach Anspruch 15, dadurch gekennzeichnet, dass $Q^4$, $Q^5$ und $Q^6$ unabhängig voneinander ein Wasserstoff- oder Fluoratom und insbesondere je ein Fluoratom darstellen.

17. Beschichtetes Substrat, enthaltend auf mindestens einer Substrat-Oberfläche eine Schicht der photopolymerisierbaren Zusammensetzung gemäss Anspruch 1.

18. Verfahren zur Herstellung von Reliefabbildungen auf Substraten, indem man ein Substrat mit einer photopolymierisierbaren Zusammensetzung gemäss Anspruch 1 beschichtet und die Schicht bildmässig belichtet, die unbelichteten Stellen mit einem Lösungsmittel entfernt und das erhaltene Bild danach durch Tempern zu einer bei hohen Temperaturen beständigen Abbildung fixiert.

**Claims**

1. A photopolymerizable composition which comprises, in addition to conventional ingredients,

(a) a prepolymer which contains identical or different recurring structural elements of the formula I

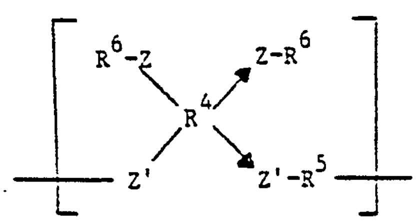

(I)

and which reacts, when heated, to form a thermally stable ring structure,

(b) a photoinitiator, and optionally

(c) an ester of acrylic or methacrylic acid, an allyl ether or an allyl ester or a partial ester of said acids with a polyol,

wherein the photoinitiator (b) is a metallocene of the formula II

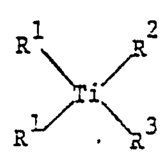

(II)

wherein

both $R^1$s independently of one another are unsubstituted or substituted cyclopentadienyl$^-$, indenyl$^-$, or both $R^1$s together are an unsubstituted or substituted radical of the formula III

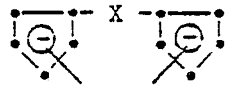

(III)

$R^2$ is a carbocyclic or 5- or 6-membered heterocyclic aromatic ring which is substituted in at least one of the two ortho-positions relative to the metal-carbon bond by a fluorine atom and which may contain further substituents,

$R^3$ is $C_3$-$C_5$ alkynyl, substituted or unsubstituted phenyl-alkynyl containing 3 to 5 carbon atoms in the alkynyl moiety, $N_3$, CN, $Si(R^7)_3$ or $Sn(R^7)_3$, or has the meaning of $R^2$, or $R_2$ and $R_3$ together are a radical of the formula IV

—Q—Y—G— (IV)

$R^4$ is a tetravalent aromatic radical after removal of four functional groups, with any two functional groups being adjacent and → denoting structural isomers,

$R^5$ is a divalent aliphatic, cycloaliphatic or mononuclear or polynuclear aromatic radical, and aromatic radicals $R^5$ may contain a —$CONH_2$ or —COOH group in the ortho-position to the bond to Z',

$R^6$ is a radical containing a photopolymerizable olefinic double bond,

$R^7$ is $C_1$-$C_{12}$ alkyl, $C_5$-$C_{12}$ cycloalkyl, $C_6$-$C_{16}$ aryl or $C_7$-$C_{16}$ aralkyl,

Z is a covalent or ionic bond and Z' is a covalent bond with the proviso that, on heating the photopolymerizable composition to remove the radical $R^6$, Z and Z', optionally together with —$CONH_2$ or —COOH groups contained in $R^5$, form a thermally stable ring structure,

X is $(CH_2)_n$, in which n is 1, 2 or 3, alkylidene containing 2 to 12 carbon atoms, cycloalkylidene containing 5 to 7 ring carbon atoms, $Si(R^7)_2$ or $Sn(R^7)_2$,

Q is a carbocyclic or heterocyclic 5- or 6-membered aromatic ring, each of the two bonds being in the ortho-position to the group Y and each meta-position to the group y being substituted by a fluorine atom, and Q may contain further substituents, and Y is $CH_2$, alkylidene containing 2 to 12 carbon atoms, cycloalkylidene containing 5 to 7 ring carbon atoms, a direct bond, $NR^7$, O, S, SO, $SO_2$, CO, $Si(R^7)_2$ or $Sn(R^7)_2$.

2. A composition according to Claim 1, which contains 50 to 97.5 % by weight of component (a) and 2.5 to 50 % by weight of component (c), based on components (a) and (c).

3. A composition according to Claim 1, which contains the photoinitiator (b) in an amount of 0.1 to 20 % by weight, based on component (a) or on components (a) and (c).

4. A composition according to Claim 1, wherein Z is —COO—, —CONH—, —O—, —NH—, —$COOH/NR^{14}R^{15}$— or

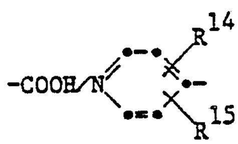

,

Z' is —CONH—, —NHCO—, —NH—CO—NH— or —O—CO—NH—, and $R^{14}$ and $R^{15}$ independently of one another are alkyl or alkenyl having up to 6 carbon atoms.

5. A composition according to Claim 1, wherein Z is —CONH—, —COO— or —$COOH/N(CH_3)_2$— and Z' is —CONH—, or Z is —O— and Z' is —NHCO—.

6. A composition according to Claim 1, wherein

$R^4$ is a radical of the formula V or VI

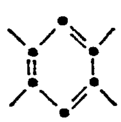

(V) or

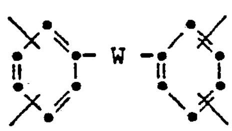

(VI)

$R^5$ is a radical of the formulae VII, VIII or IX

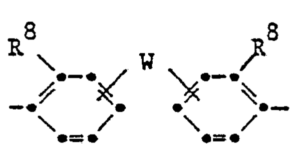

(VII)

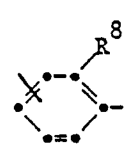

(VIII)

or

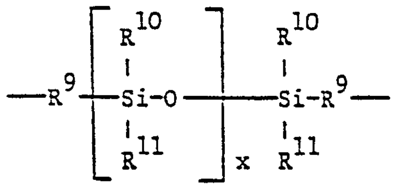 (IX) and

$R^6$ is a radical of the formula X

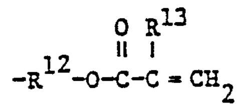 (X)

or, if Z is —COO—, is also $—CH = CH_2$, $—CH_2CH = CH_2$ or $—CH_2C(CH_3) = CH_2$, wherein

W is a direct bond, O, CO, $CH_2$, $C(CF_3)_2$, S, SO, $SO_2$, NH or alkylidene containing 2 to 12 carbon atoms,

x is an integer from 1 to 10, in particular from 1 to 5,

$R^8$ is each independently of the other a hydrogen atom, $—CONH_2$ or —COOH,

$R^9$ is $—C_pH_{2p}—$, in which p = 1 to 5,

$R^{10}$ and $R^{11}$ independently of one another are straight chain or branched alkyl containing 1 to 6 carbon atoms, methyl, in particular,

$R^{12}$ is $—C_mH_{2m}—$, in which m = 2 to 12, $—CH_2CH(OH)CH_2—$ or polyoxa-alkylene containing 4 to 30 carbon atoms, and

$R^{13}$ is a hydrogen atom or methyl,

where $R^4$, $R^5$ and $R^6$ in the individual structural elements may have identical or differing meanings.

7. A composition according to Claim 6, wherein $R^5$ in 0 to 100 % of the recurring structural elements is a radical of the formula VII and in 100 to 0 % of the recurring structural elements is a radical of the formula VIII.

8. A composition according to Claim 6, wherein $R^5$ in 70 to 100 % of the recurring structural elements is a radical of the formula VII and/or VIII, and in 30 to 0 % of the recurring structural elements is a radical of the formula IX.

9. A composition according to Claim 1, wherein the prepolymer (a) contains recurring structural elements of the formula Ia

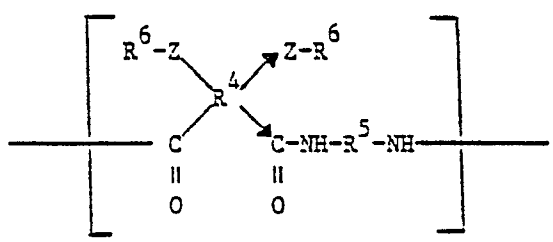 (Ia)

wherein $R^4$ is the tetravalent radical of an aromatic tetracarboxylic acid after removal of four carboxyl groups, and $R^5$, $R^6$ and Z are as defined in Claim 1.

10. A composition according to Claim 9, wherein Z is —CO—O—.

11. A composition according to Claim 1, wherein the prepolymer (a) consists of recurring structural elements of the formula Ic

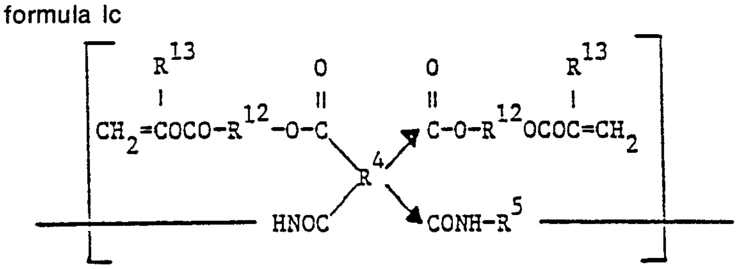 (Ic)

wherein $R^4$ is the radical of pyromellittic dianhydride, of a benzophenonetetracarboxylic dianhydride or a mixture of such radicals, each $R^5$ in the individual recurring structural elements is independently of the other 1,3- or 1,4-phenylene, the radical of 4,4′-diaminodiphenyl ether, 4,4′-diaminodiphenylmethane, 2,2-bis-(4,4′-diaminodiphenyl)-hexafluoropropane, 4,4′-diamino-3-carboxamidodiphenyl ether or 4,4′-diamino-3,3′-bis-carboxamidobiphenyl, $R^{12}$ is $—CH_2CH_2—$ or $—CH_2CH(OH)CH_2—$ and $R^{13}$ is a hydrogen atom or methyl.

12. A composition according to Claim 1, wherein the prepolymer consists of recurring structural elements of the formula Id

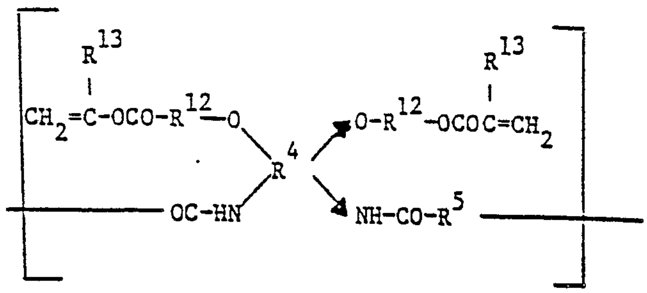

(Id)

wherein $R^4$ is the radical of 3,3'-dihydroxybenzidine, each $R^5$ in the individual recurring structural elements is independently of the other 1,3-phenylene or is the radical of 4,4'-benzo-phenonedicarboxylic acid, $R^{12}$ is $-CH_2-CH_2-$, $-CH_2CH_2CH_2-$ or $-CH_2CH(OH)CH_2-$, and $R^{13}$ is a hydrogen atom or methyl.

13. A composition according to Claim 1, wherein component (c) is an ester or a partial ester of acrylic or methacrylic acid and aliphatic polyols of 2 to 30 carbon atoms or cycloaliphatic polyols containing 5 or 6 ring carbon atoms.

14. A composition according to Claim 1, wherein each of $R^2$ and $R^3$ in formula II is unsubstituted or substituted 2,6-difluorophen-1-yl or $R^2$ and $R^3$ together are a radical of the formula XI

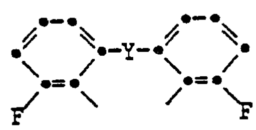

(XI)

wherein Y is a direct bond, $CH_2$ or O.

15. A composition according to Claim 1, wherein each $R^1$ in formula II is unsubstituted $\pi$-cyclopentadienyl or $\pi$-cyclopentadienyl which is substituted by $C_1$-$C_4$ alkyl, in particular methyl, and each of $R^2$ and $R^3$ is a radical of the formula XII

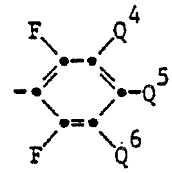

(XII)

wherein $Q^4$, $Q^5$ and $Q^6$ independently of one another are H, F, Cl, Br or a tertiary amino group.

16. A composition according to Claim 15, wherein $Q^4$, $Q^5$ and $Q^6$ independently of one another are a hydrogen or fluorine atom, and in particular are each a fluorine atom.

17. A coated substrate which contains on at least one substrate surface a layer of the photopolymerizable composition according to Claim 1.

18. A process for the production of relief images on substrates, which comprises coating a substrate with a photopolymerizable composition according to Claim 1 and exposing the layer imagewise, removing the unexposed parts with a solvent and subsequently fixing the resultant image by baking to give an image which is resistant to high temperatures.

**Revendications**

1. Composition photopolymérisable qui, en plus d'additifs usuels, contient :

a) un précurseur polymère à motifs (éléments structuraux répétés), identiques ou différents, répondant à la formule I :

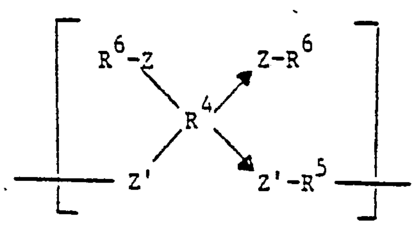

(I)

qui réagit, lorsqu'il est chauffé, en donnant une structure cyclique thermostable,

b) un photo-amorceur et, éventuellement,

c) un ester de l'acide acrylique, un ester de l'acide méthacrylique, un éther allylique ou un ester allylique ou un ester partiel de ces acides avec un polyol,

composition caractérisée en ce que le photo-amorceur (b) est un métallocène de formule II :

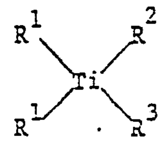

(II)

formules dans lesquelles :

les $R^1$ représentent chacun, indépendamment l'un de l'autre, un radical cyclopentadiényle ⊖ ou indényle ⊖, substitué ou non, ou les deux $R^1$ forment ensemble un radical, substitué ou non, qui répond à la formule III :

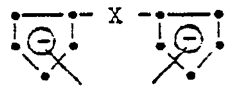

(III)

$R^2$ représente un noyau carbocyclique ou un noyau aromatique hétérocyclique à 5 ou 6 maillons, qui porte un atome de fluor en au moins une des deux positions ortho par rapport à la liaison métal-carbone et qui peut porter d'autres substituants,

$R^3$ représente un alcynyle en $C_3$-$C_5$, un phénylalcynyle, substitué ou non, qui contient de 3 à 5 atomes de carbone dans son radical alcynyle, $N_3$ CN, $Si(R^7)_3$ ou $Sn(R^7)_3$ ou a la signification de $R^2$, ou encore $R^2$ et $R^3$ forment ensemble un radical de formule IV :

$$—Q—Y—Q— \quad (IV),$$

$R^4$ représente un radical aromatique quadrivalent qui reste après élimination de 4 radicaux fonctionnels, en l'espèce de deux couples de radicaux fonctionnels voisins, et le signe « → » veut dire qu'on a affaire à des isomères de structure,

$R^5$ représente un radical bivalent aliphatique ou cycloaliphatique ou un radical bivalent aromatique à 1 ou plusieurs noyaux, des radicaux aromatiques $R^5$ pouvant porter, en position ortho par rapport à la liaison à Z', un radical $—CONH_2$ ou —COOH,

$R^6$ représente un radical contenant une double liaison éthylénique photopolymérisable,

$R^7$ représente un alkyle en $C_1$-$C_{12}$, un cycloalkyle en $C_5$-$C_{12}$, un aryle en $C_6$-$C_{16}$ ou un aralkyle en $C_7$-$C_{16}$,

les Z représentent un maillon de liaison covalent ou ionique et les Z' représentent un maillon de liaison covalent, avec la condition que Z et Z', lorsque la composition photopolymérisable est chauffée, engendre une structure cyclique thermostable par une réaction se produisant avec enlèvement de $R^6$, éventuellement avec des radicaux $—CONH_2$ ou —COOH contenus dans $R^5$,

X représente un radical $(CH_2)_n$ dont l'indice n est égal à 1, à 2 ou à 3, un alkylidène contenant de 2 à 12 atomes de carbone, un cycloalkylidène contenant de 5 à 7 atomes de carbone dans son cycle, un radical $Si(R^7)_2$ ou un radical $Sn(R^7)_2$,

Q représente un noyau aromatique pentagonal ou hexagonal qui est carbocyclique ou hétérocyclique, les deux liaisons étant chacune en position ortho par rapport au radical Y, la position méta par rapport au radical Y étant à chaque fois occupée par un atome de fluor, et Q pouvant porter d'autres substituants, et Y représente $CH_2$, un alkylidène contenant de 2 à 12 atomes de carbone, un cycloalkylidène contenant de 5 à 7 atomes de carbone dans son cycle, une liaison directe, $NR^7$, O, S, SO, $SO_2$, CO, $Si(R^7)_2$ ou $Sn(R^7)_2$.

2. Composition selon la revendication 1 caractérisée en ce qu'elle contient de 50 à 97,5 % en poids de la composante (a) et de 2,5 à 50 % en poids de la composante (c), par rapport aux composantes (a) et (c).

3. Composition selon la revendication 1 caractérisée en ce que le photo-amorceur (b) est présent en une quantité de 0,1 à 20 % en poids, par rapport à la composante (a) ou aux composantes (a) et (c).

4. Composition selon la revendication 1 dans laquelle Z représente —COO—, —CONH—, —O—, —NH—, $—COOH/NR^{14}R^{15}—$ ou

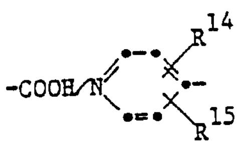

,

Z' représente un radical —CONH—, —NHCO—, —NH—CO—NH— ou —O—CO—NH—, et $R^{14}$ et $R^{15}$ représentent chacun, indépendamment l'un de l'autre, un radical alkyle ou alcényle contenant au plus 6 atomes de carbone.

5. Composition selon la revendication 1 dans laquelle Z représente un radical —CONH—, —COO— ou $—COOH/N(CH_3)_2—$ et Z' représente un radical —CONH—, ou Z représente —O— et Z' un radical —NHCO—.

6. Composition selon la revendication 1 dans laquelle :

$R^4$ représente un radical de formule V ou VI :

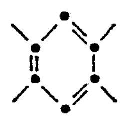 (V) 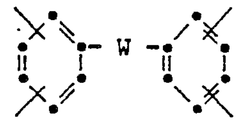 (VI)

$R^5$ représente un radical de formule VII, VIII ou IX :

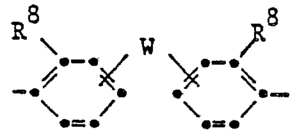 (VII) 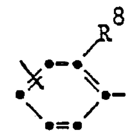 (VIII)

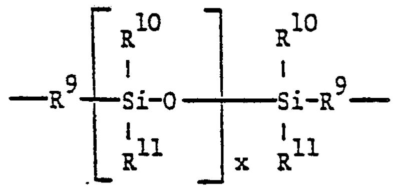 (IX)

$R^6$ représente un radical de formule X :

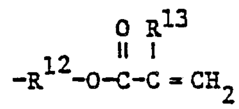 (X)

ou, dans le cas où Z est un radical —COO—, $R^6$ peut aussi représenter un radical $—CH=CH_2$, $—CH_2CH=CH_2$ ou $—CH_2C(CH_3)=CH_2$,

W représente une liaison directe, O, CO, $CH_2$, $C(CF_3)_2$, S, SO, $SO_2$, NH ou un alkylidène en $C_2$-$C_{12}$,

x désigne un nombre de 1 à 10, en particulier de 1 à 5,

les $R^8$ représentent chacun, indépendamment l'un de l'autre, un atome d'hydrogène ou un radical $—CONH_2$ ou —COOH,

$R^9$ représente un radical $—C_pH_{2p}—$ dont l'indice p est un nombre de 1 à 5,

$R^{10}$ et $R^{11}$ représentent chacun, indépendamment l'un de l'autre, un radical alkyle linéaire ou ramifié qui contient de 1 à 6 atomes de carbone, en particulier un radical méthyle,

$R^{12}$ représente un radical $—C_mH_{2m}—$ dont l'indice m est un nombre de 2 à 12, un radical $—CH_2CH(OH)CH_2—$ ou un radical poly-(oxa-alkylène) contenant de 4 à 30 atomes de carbone, et

$R^{13}$ représente un atome d'hydrogène ou un radical méthyle,

les symboles $R^4$, $R^5$ et $R^6$ ayant, dans les divers motifs, des significations identiques ou différentes.

7. Composition selon la revendication 6 dans laquelle $R^5$ représente un radical de formule VII dans 0 à 100 % des motifs et un radical de formule VIII dans 100 à 0 % des motifs.

8. Composition selon la revendication 6 dans laquelle $R^5$ représente, dans 70 à 100 % des motifs, un radical de formule VII et/ou de formule VIII et, dans 30 à 0 % des motifs, un radical de formule IX.

9. Composition selon la revendication 1 dans laquelle le précurseur polymère (a) contient des éléments structuraux répétés (motifs) répondant à la formule Ia :

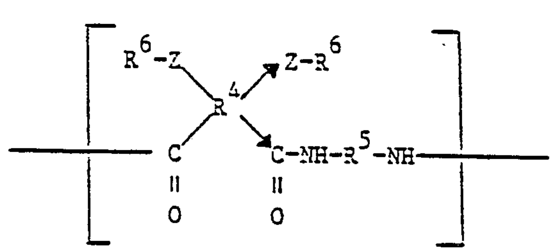 (Ia)

dans laquelle $R^4$ représente le radical quadrivalent que laisse un acide tétracarboxylique aromatique après qu'on en a retiré quatre radicaux carboxy, et $R^5$, $R^6$ et Z ont les significations qui leur ont été données à la revendication 1.

10. Composition selon la revendication 9 dans laquelle Z représente un radical —CO—O—.

11. Composition selon la revendication 1 dans laquelle le précurseur polymère (a) est constitué de motifs répondant à la formule Ic :

(Voir formule page 37)

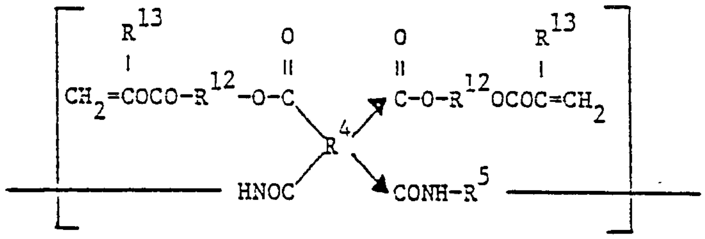

(Ic)

dans laquelle $R^4$ représente le radical du dianhydride de l'acide pyromellitique, d'un dianhydride d'acide benzophénone-tétracarboxylique ou un mélange de ces radicaux, les $R^5$ représentent chacun, indépendamment les uns des autres dans les divers motifs, un radical phénylène-1,3 ou -1,4 ou le radical de l'oxyde de bis-(amino-4 phényle), du diamino-4,4' diphénylméthane, du bis-(diamino-4,4' biphénylyl)-2,2 hexafluoropropane, de l'oxyde de carbamoyl-3 amino-4 phényle et d'amino-4 phényle ou du diamino-4,4' bis-carbamoyl-3,3' biphényle, $R^{12}$ représente un radical $-CH_2CH_2-$ ou $-CH_2CH(OH)CH_2-$ et $R^{13}$ représente un atome d'hydrogène ou un radical méthyle.

12. Composition selon la revendication 1 dans laquelle le précurseur polymère est constitué de motifs répondant à la formule Id :

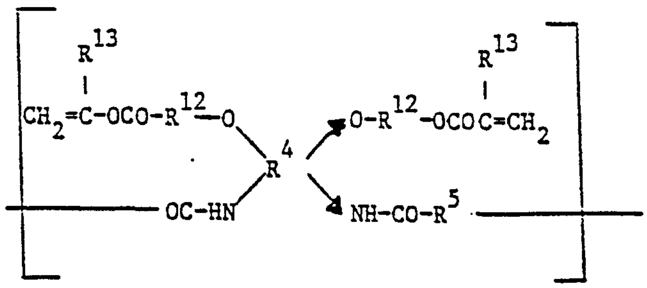

(Id)

dans laquelle $R^4$ représente le radical de la dihydroxy-3,3' benzidine, les $R^5$ représentent chacun, indépendamment les uns des autres dans les divers motifs, un radical phénylène-1,3 ou le radical de l'acide benzophénone-dicarboxylique-4,4', $R^{12}$ représente un radical $-CH_2-CH_2-$, $-CH_2CH_2CH_2-$ ou $-CH_2CH(OH)CH_2-$ et $R^{13}$ un atome d'hydrogène ou un radical méthyle.

13. Composition selon la revendication 1 caractérisée en ce que la composante (c) est un ester ou un ester partiel dérivant de l'acide acrylique ou méthacrylique et d'un polyol aliphatique contenant de 2 à 30 atomes de carbone ou d'un polyol cycloaliphatique contenant 5 ou 6 atomes de carbone dans son cycle.

14. Composition selon la revendication 1 caractérisée en ce que $R^2$ et $R^3$, dans la formule II, représentent chacun un radical difluoro-2,6 phényle substitué ou non, ou $R^2$ et $R^3$ forment ensemble un radical répondant à la formule XI :

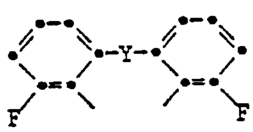

(XI)

dans laquelle Y représente une liaison directe, $CH_2$ ou O.

15. Composition selon la revendication 1 caractérisée en ce que, dans la formule II, les deux symboles $R^1$ représentent chacun un radical $\pi$-cyclopentadiényle non substitué ou porteur d'un alkyle en $C_1$-$C_4$, en particulier d'un méthyle, et $R^2$ et $R^3$ représentent chacun un radical répondant à la formule XII :

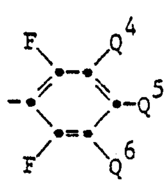

(XII)

dans laquelle $Q^4$, $Q^5$ et $Q^6$ représentent chacun, indépendamment les uns des autres, H, F, Cl ou Br ou un radical amino tertiaire.

16. Composition selon la revendication 15 caractérisée en ce que $Q^4$, $Q^5$ et $Q^6$ représentent chacun, indépendamment les uns des autres, un atome d'hydrogène ou un atome de fluor, plus particulièrement chacun un atome de fluor.

17. Substrat revêtu qui porte, sur au moins l'une de ses surfaces, une couche de la composition photopolymérisable selon la revendication 1.

18. Procédé pour réaliser des images en relief sur des substrats, selon lequel on enduit un substrat avec une composition photopolymérisable selon la revendication 1, on expose la couche à un rayonnement conformément à une image, on élimine au moyen d'un solvant les endroits qui n'ont pas été touchés par le rayonnement et on fixe ensuite l'image obtenue par cuisson, de manière à obtenir une image résistant aux températures élevées.